# EUROPEAN PATENT APPLICATION

(11) **EP 3 940 794 A1**
(43) Date of publication of application: **19.01.2022**
(21) Application number: 20773436.9
(22) Date of filing: 13.03.2020
(51) Int. Cl.: H01L 31/0224, H01L 31/18, H01L 31/05

(54) **SOLAR BATTERY MODULE MANUFACTURING METHOD, SOLAR BATTERY MODULE, AND RAW MATERIAL SOLAR BATTERY CELL**

(30) Priority: 15.03.2019 JP 2019048942
(71) Applicant: Kaneka Corporation, Osaka-shi, Osaka 530-8288 (JP)
(72) Inventor: MAEDA Kengo, Osaka-shi, Osaka 530-8288 (JP); MAKINO Tsukasa, Osaka-shi, Osaka 530-8288 (JP); MATSUO Hideki, Osaka-shi, Osaka 530-8288 (JP)
(74) Representative: Hoffmann Eitle
(86) International application number: PCT/JP2020/011154
(87) International publication number: WO 2020/189562

(57) **Abstract**

The present invention provides a method for manufacturing a solar cell module, a solar cell module, and a raw material solar cell, which can be manufactured more easily than conventional ones. Provided is a method for manufacturing a solar cell module in which a plurality of solar cells including a cell electrode layer and a connection electrode are electrically connected directly or via a connection member, the connection electrode being an electrode that connects the connection member or the connection electrode of another solar cell to the cell electrode layer, wherein the method includes a raw material cell manufacturing step of manufacturing a raw material solar cell with a pair of electrode layers, a photoelectric conversion part sandwiched by the pair of electrode layers, and a connection electrode formation part; and a cell dividing step of dividing the raw material solar cell into a plurality of pieces to form the solar cell, wherein in the cell dividing step, the connection electrode formation part is cut and form the connection electrode.

## Description

### TECHNICAL FIELD

The present invention relates to a method for manufacturing a solar cell module, a solar cell module, and a raw material solar cell.

### BACKGROUND ART

In recent years, solar cell modules have attracted attention as an energy source having a low environmental load.

A solar cell module is generally formed by sealing a plurality of solar cells between a glass substrate and a back sheet. For example, a crystalline silicon solar cell module has a structure in which a plurality of solar cells are electrically connected by wiring members such as tab lines to form cell rows, which are sealed inside the module.

When solar cells to be adopted in the solar cell module of this type are manufactured, a known method is to laminate each layer on a crystalline silicon substrate that is cut out from an ingot to prepare a work-in-process, and the work-in-process is divided into solar cell pieces.

For example, in the method disclosed in Patent Document 1, laser light is emitted onto one main surface side of a plate-shaped work-in-process to form dividing grooves on the work-in-process, and then the work- in-process is folded and cut into crystalline silicon solar cells. Then, electrodes such as for finger electrodes and bus bar electrodes are appropriately formed on the crystalline silicon solar cell for the use as a solar cell.

### PRIOR ART DOCUMENT

### PATENT DOCUMENT

Patent Document 1: JP 6360340 B2

### DISCLOSURE OF INVENTION

### TECHNICAL PROBLEM

In the above method, however, there is room for improvement from the viewpoint of facilitating the manufacture of a solar cell module, such as easier mass production possibility of small solar cells.

Therefore, a challenge of the present invention is to provide a method for manufacturing a solar cell module, a solar cell module, and a raw material solar cell, which can be manufactured more easily than conventional ones.

### SOLUTION TO PROBLEM

One aspect of the present invention for achieving the above challenge is a method for manufacturing a solar cell module including a plurality of solar cells, the plurality of solar cells being electrically connected directly or via a connection member, wherein the solar cell includes: a cell electrode layer; and a connection electrode, the plurality of solar cells including a first and a second solar cells, the connection electrode of the first solar cell being configured to connect the connection member or the connection electrode of the second solar cell to the cell electrode layer of the first solar cell, wherein the method includes: (a) manufacturing a raw material solar cell, the raw material solar cell including: a pair of electrode layers; a photoelectric conversion part sandwiched between the pair of electrode layers; and a connection electrode formation part; and (b) dividing the raw material solar cell into plural pieces to form the solar cells, and wherein step (b) includes cutting the connection electrode formation part to form the connection electrode.

According to the present aspect, a raw material cell manufacturing step of manufacturing a raw material solar cell is included, the raw material solar cell being provided with a connection electrode formation part to be a connection electrode of a solar cell. According to the present aspect, the connection electrode formation part is cut by a cell dividing step of dividing the raw material solar cell to form a solar cell having the connection electrode. That is, according to the present aspect, by dividing the connection electrode formation part provided in advance in the raw material solar cell to form the connection electrode, it is not necessary to form a connection electrode in each of the divided pieces, which facilitates the manufacture of a solar cell.

In a preferred aspect, the connection electrode formation part includes a cutting region with a lower flexural rigidity than other portions in the connection electrode formation part, and step (b) includes cutting the cutting region.

In a more preferred aspect, the cutting region includes at least one of the following (1) to (4): (1) one or more through holes, (2) one or more notches, (3) one or more recesses, and (4) one or more grooves.

In a more preferred aspect, step (b) includes: (c) forming a dividing groove in the raw material solar cell by laser-processing; and (d) folding and cutting the raw material solar cell along the dividing groove after step (c).

In a more preferred aspect, the raw material solar cell includes: a first main surface; and a second main surface, the connection electrode formation part includes: a first connection electrode formation part provided on the first main surface side; and a second connection electrode formation part provided on the second main surface side, and the cutting region of the first connection electrode formation part is divided in step (d) whereas the cutting region of the second connection electrode formation part is divided in step (c).

In a preferred aspect, the raw material solar cell includes: a first main surface; a second main surface; and a current collecting electrode, the current collecting electrode including: a first current collecting electrode provided on the first main surface side; and a second current collecting electrode provided on the second main surface side, and when the raw material solar cell is planarly viewed, the first current collecting electrode extends in the same direction as the second current collecting electrode while most of the first current collecting electrode overlaps with the second current collecting electrode.

The term "most" used here means a portion exceeding 50% of the whole.

In a preferred aspect, the method includes (e) converting light energy into electric energy by connecting an external load to the raw material solar cell before step (b).

The term "external load" used here means one that is connected to an output of a circuit or a device and consumes the current or energy supplied by the circuit or the device, and specifically means a power load such as a solar simulator or an IV measuring instrument such as an IV curve tracer.

One aspect of the present invention is a solar cell module including a cell group having a plurality of solar cells electrically connected directly or via a connection member, wherein the solar cell includes: a pair of cell electrode layers; a photoelectric conversion part sandwiched between the pair of cell electrode layers; and a connection electrode extending in a predetermined direction, wherein the plurality of solar cells include a first and a second solar cells, wherein the connection electrode of the first solar cell is configured to connect the connection member or the connection electrode of the second solar cell to the cell electrode layer of the first solar cell, and wherein the connection electrode includes: a cut surface part forming an end surface in a longitudinal direction; and a cut structure mark part continuous with the cut surface part, the cut structure mark part being a notch and/or a thin part.

According to the present aspect, the solar cell module can be manufactured by the above method for manufacturing a solar cell module, and can be easily manufactured.

In a preferred aspect, the connection electrode includes a through hole in a longitudinal middle part, the through hole penetrating in a thickness direction.

The term "middle part" used here means a part other than ends, and the term "longitudinal middle part" means a portion between one end and the other end in the longitudinal direction.

In a preferred aspect, the cell group is constituted by arranging linearly the plurality of solar cells, and when planarly viewed, a longitudinal direction of the connection electrode intersects with a row direction of the plurality of solar cells.

In a preferred aspect, a side surface of the solar cell includes: a laser processing region including a laser-processed mark; and a folding region including a folded mark, and the laser processing region has a surface roughness larger than a surface roughness of the folding region.

In a preferred aspect, the solar cell extends in a predetermined direction with a width, the solar cell having a longitudinal direction length longer than 5 times and shorter than 100 times its width, the solar cell includes: a current collecting electrode; and an auxiliary electrode, the current collecting electrode extending along a longitudinal direction of the solar cell; the auxiliary electrode and the connection electrode extending in a direction intersecting with the longitudinal direction of the solar cell when planarly viewed, each of the auxiliary electrode and the connection electrode being in contact with the current collecting electrode, the connection electrode is located at or near one end in the longitudinal direction of the solar cell; and the auxiliary electrode is located between the center and the other end in the longitudinal direction of the solar cell.

One aspect of the present invention is a solar cell module including a cell group having a plurality of solar cells connected directly or via a connection member, wherein the solar cell extends in a predetermined direction with a width, the solar cell having a longitudinal direction length longer than 5 times and shorter than 100 times its width, wherein the solar cell includes: a pair of cell electrode layers; a photoelectric conversion part sandwiched between the pair of cell electrode layers; a connection electrode; a current collecting electrode; and an auxiliary electrode, the plurality of solar cells including a first and a second solar cells, the connection electrode of the first solar cell being configured to connect the connection member or the connection electrode of the second solar cell to the cell electrode layer of the first solar cell, the current collecting electrode extending in a longitudinal direction of the solar cell from the connection electrode, the auxiliary electrode and the connection electrode extending in a direction intersecting with the longitudinal direction of the solar cell when planarly viewed, each of the auxiliary electrode and the connection electrode being in contact with the current collecting electrode, wherein the connection electrode is located near one end in the longitudinal direction of the solar cell, and wherein the auxiliary electrode is located between the center and the other end in the longitudinal direction of the solar cell.

According to the present aspect, the solar cell module can be manufactured by the above method for manufacturing a solar cell module, and can be easily manufactured.

According to the present aspect, the connection electrode is located near one end of the solar cell, so that it can be easily connected.

According to the present aspect, the auxiliary electrode is provided on the opposite side to the connection electrode, so that resistance loss can be reduced even if the solar cell has a long shape such as the longitudinal direction length is longer than the width direction length.

One aspect of the present invention is a solar cell module including a cell group having a plurality of solar cells electrically connected directly or via a connection member, wherein the solar cell includes: a pair of cell electrode layers; a photoelectric conversion part sandwiched between the pair of cell electrode layers; a connection electrode; and a current collecting electrode, the plurality of solar cells including a first and a second solar cells, the connection electrode of the first solar cell being configured to connect the connection member or the connection electrode of the second solar cell to the cell electrode layer of the first solar cell, the current collecting electrode extending in a longitudinal direction of the solar cell, the connection electrode with a width extending in a direction intersecting with the longitudinal direction of the solar cell when planarly viewed, the connection electrode having a width larger than a width of the current collecting electrode, the connection electrode having an end surface constituted by a cut surface in its extending direction.

According to the present aspect, the solar cell module can be manufactured by the above method for manufacturing a solar cell module, and is easily manufactured.

One aspect of the present invention is a raw material solar cell that includes a connection electrode formation part and that is to be divided into a plurality of solar cells by cutting the connection electrode formation part, the raw material solar cell including: a pair of electrode layers; and a photoelectric conversion part sandwiched between the pair of electrode layers, wherein the photoelectric conversion part is configured to convert light energy into electric energy, wherein the connection electrode formation part is configured to be electrically connected to the electrode layer, the connection electrode formation part including a cutting region with a flexural rigidity lower than other portions; and wherein the light energy can be converted into the electric energy for extraction by connecting an external load to the connection electrode formation part.

According to the present aspect, the raw material solar cell can be used in the above method for manufacturing a solar cell module, and a solar cell module as a product is easily manufactured.

According to the present aspect, an output can be confirmed in the state of the raw material solar cell, so that yield can be improved.

### EFFECT OF INVENTION

According to the present invention, a solar cell module can be easily manufactured.

### BRIEF DESCRIPTION OF DRAWINGS

Fig. 1 is a perspective view showing a state where solar cell modules according to an embodiment of the present invention are used as window portions of an apartment building.
Fig. 2 is a plan view showing the solar cell module of Fig. 1, wherein solar cells and wiring members are schematically shown.
Fig. 3 is a partially exploded perspective view showing a module main body and a terminal box of Fig. 2, wherein the module main body is shown disassembled in a state before lamination.
Fig. 4 is a perspective view showing the solar cell of Fig. 2.
Figs. 5A and 5B are plan views showing the solar cell of Fig. 2, Fig. 5A being a plan view from one side in the thickness direction, Fig. 5B being a plan view from the other side in the thickness direction.
Fig. 6 is a cross-sectional view schematically showing an A-A cross section of the solar cell in Fig. 4.
Fig. 7 is a perspective view showing the periphery of an end of the solar cell of Fig. 4, with an enlarged view of a part of the end.
Fig. 8 is a plan view showing the periphery of an end of the solar cell of Fig. 4.
Fig. 9 is a plan view showing, in an enlarged manner, the periphery of a cell row assembly of Fig. 2.
Fig. 10A is a perspective view showing, in an enlarged manner, a part of the cell row of Fig. 2, and Fig. 10B is a side view schematically showing a part of the cell row of Fig. 10A.
Fig. 11 is an explanatory view schematically showing, in an enlarged manner, the periphery of a second interconnector connecting the cell rows of Fig. 2 to each other.
Figs. 12A and 12B are plan views showing a raw material solar cell, wherein 12A shows a state viewed from a first main surface side, and 12B shows a state viewed from a second main surface side.
Fig. 13A and 13B are explanatory views schematically showing the raw material solar cell without finger electrodes, wherein 13A shows a state viewed from the first main surface side, and 13B shows a state viewed from the second main surface side.
Fig. 14 is an explanatory view showing, in an enlarged manner, the periphery of a low rigidity part of Figs. 12A and 12B, a part of the periphery being also shown in a further enlarged manner.
Figs. 15A and 15B are views showing the raw material solar cell of Figs. 13A and 13B, and explanatory views showing a first raw material part and a second raw material part by dots, wherein 15A shows a state viewed from the first main surface side and 15B shows a state viewed from the second main surface side.
Figs. 16A and 16B are views showing the raw material solar cell of Fig. 13, and are explanatory views showing positions of dividing lines in a cell dividing step, wherein 16A shows a state viewed from the first main surface side, and 16B shows a state viewed from the second main surface side.
Figs. 17A and 17B are explanatory views schematically showing a state of dividing the raw material solar cell in the cell dividing step, and are views showing a part of a B-B cross section of Fig. 12A, Fig. 17A showing a state after a laser processing step, Fig. 17B showing a state after a folding step.
Figs. 18A and 18B are views showing a part of a C-C cross section of Fig. 12B, Fig. 18A showing a state after the laser processing step, Fig. 18B showing a state after the folding step.
Fig. 19 is an explanatory view showing a part of Fig. 17B in an enlarged manner.
Fig. 20A is a view showing, in an enlarged manner, a part of the surface of a laser processing region of Fig. 19, with an explanatory view in which a part of the enlarged portion is also shown in a further enlarged manner. Fig. 20B is an explanatory view showing, in an enlarged manner, a part of the surface of the folding region of Fig. 19.
Figs. 21A, 21B, and 21C are explanatory views each showing a low rigidity part according to an embodiment different from the above embodiment, and each of Figs. 21A to 21C shows a different low rigidity part.
Figs. 22A and 22B are explanatory views showing bus bar electrodes of a raw material solar cell according to an embodiment different from the above embodiment, and each of the Figs. 22A and 22B shows a different bus bar electrode.
Fig. 23 is an explanatory view showing a bus bar electrode of a raw material solar cell according to a different embodiment.

### BEST MODE FOR CARRYING OUT THE INVENTION

Hereinafter, a solar cell module 1 according to an embodiment of the present invention and a method for manufacturing the same will be described in detail with reference to the drawings, but the present invention is not limited to these examples. For convenience of drawing, only parts of some drawings may have reference signs, while the other parts may not.

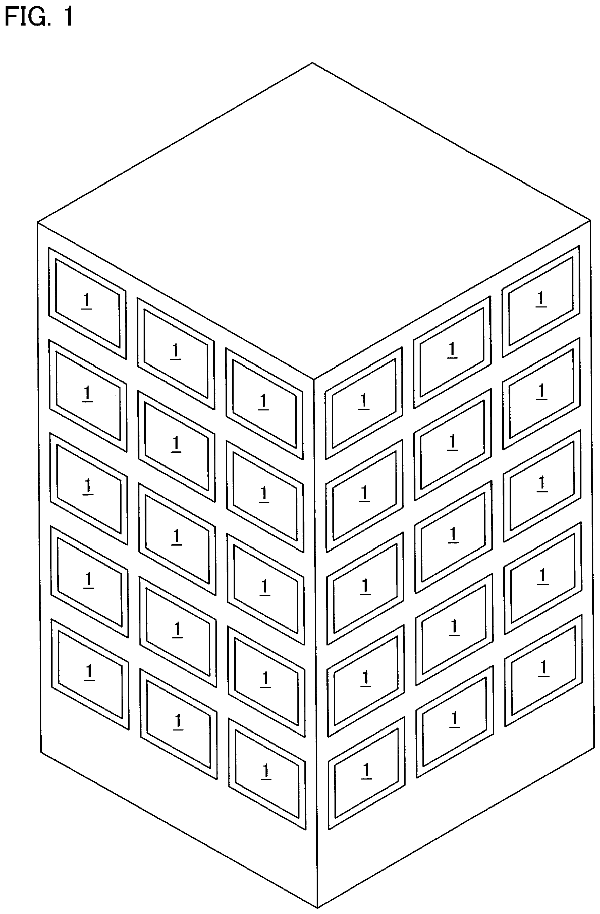

The solar cell module 1 of the present embodiment is a solar cell module of see-through type, and can be attached to an opening portion formed on a wall of a building or the like in order to be used as a window, as shown in Fig. 1. That is, the solar cell module 1 can be used as a building material (wall material, building material with solar cells) that forms a wall constructing at least a part of a building or a structure.

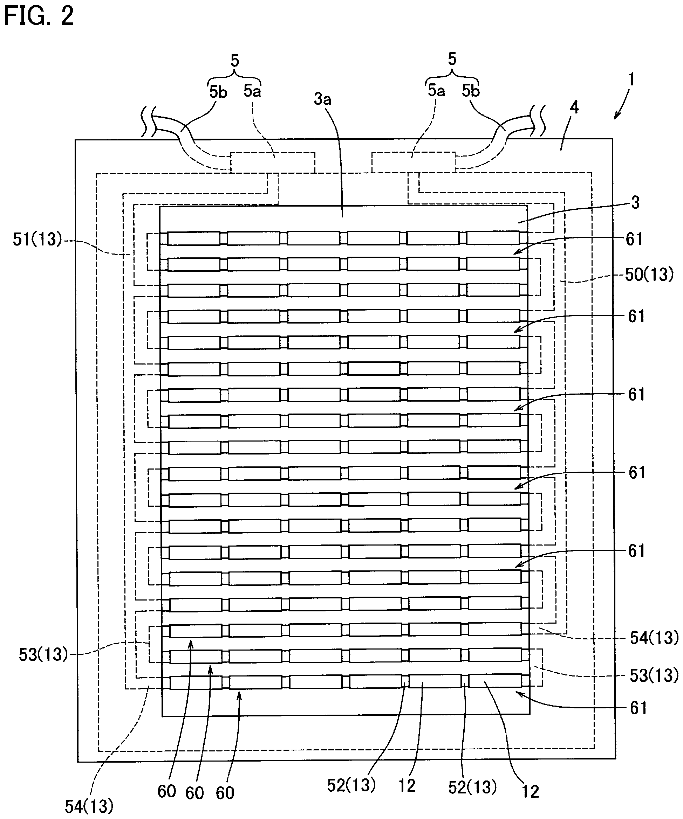

As shown in Fig. 2, the solar cell module 1 is formed by attaching a frame member 4 and a terminal box 5 to a module main body 3. The solar cell module 1 has a standing plate shape as a whole, and is assumed to be used in an upright posture.

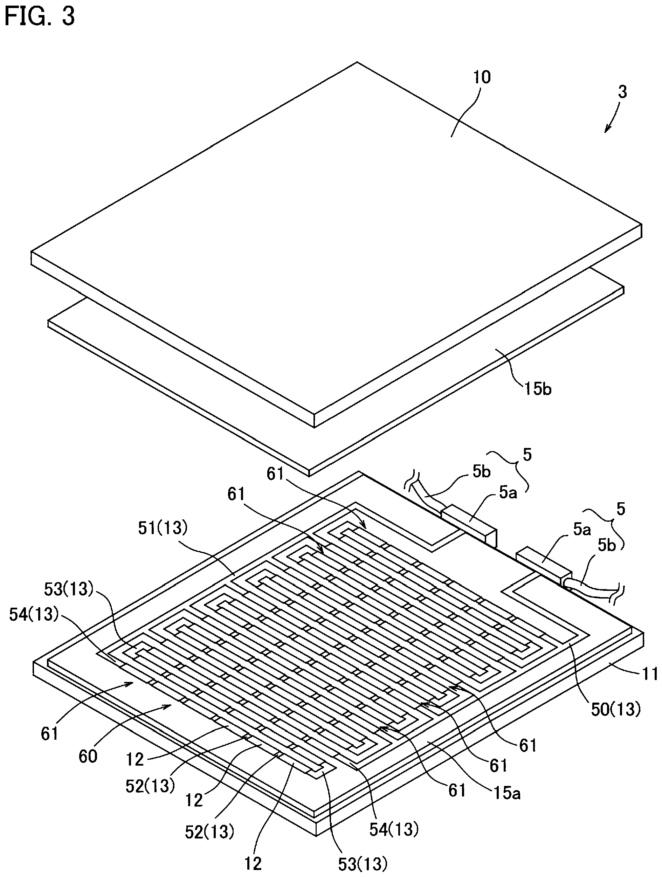

As shown in Fig. 3, the module main body 3 is formed by sealing solar cells 12 and wiring members 13 (connection members), which are interconnectors such as tab lines, between a first transparent substrate 10 and a second transparent substrate 11.

The module main body 3 is formed by stacking the second transparent substrate 11, a sealing sheet 15a, the solar cells 12 and the wiring members 13, a sealing sheet 15b, and the first transparent substrate 10 in this order from one side in the thickness direction (see Fig. 3) and then by subjecting them to lamination processing.

Note that the two sealing sheets 15a, 15b are heated at the time of the lamination processing, so that each of them melts and flows to form one sealing layer (not shown) that adheres to each of the transparent substrates 10, 11. That is, in the module main body 3, the portion between the transparent substrates 10, 11 is filled with a sealing material (filler) whose raw materials are the sealing sheets 15a, 15b, so that the sealing layer is formed. Then, the solar cells 12 and the wiring members 13 are sealed by the sealing layer.

The transparent substrates 10, 11 are transparent insulating substrates having translucency and insulating properties, and a glass substrate, a transparent resin substrate, or the like can be adopted. For the transparent substrates 10, 11 of the present embodiment, a glass substrate is adopted.

For the sealing sheets 15a, 15b, a resin sheet having adhesiveness, translucency, and insulating properties can be adopted. In the present embodiment, an EVA (ethylene-vinyl acetate copolymer resin) sheet is adopted.

As shown in Fig. 2, the frame member 4 is a metal frame that covers the edge portion of the module main body 3. The frame member 4 of the present embodiment houses in its inside the edge portion of the module main body 3 and the terminal boxes 5.

As shown in Figs. 2 and 3, the terminal box 5 includes a main body box 5a and a cable 5b.

As shown in Fig. 3, the main body box 5a is attached to the edge portion of the module main body 3.

The cable 5b is used to extract out the power generated by the solar cell module 1. The cable 5b extends inside and outside the main body box 5a, with one end drawn into the inside of the main body box 5a.

Here, into the main body box 5a, the wiring member 13 (specifically, first extraction wire 50, second extraction wire 51) is drawn. The portion located near the one end of the cable 5b and these wiring members 13 are electrically connected inside the main body box 5a.

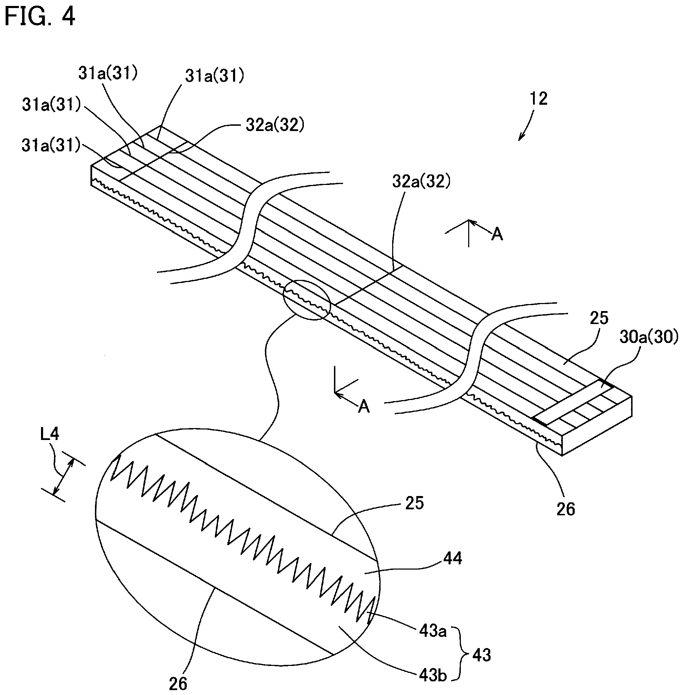

As shown in Fig. 4, the solar cell 12 having an outline of a strip-shaped plate extends in a predetermined direction with a width, and has a longer longitudinal direction length than a width direction length.

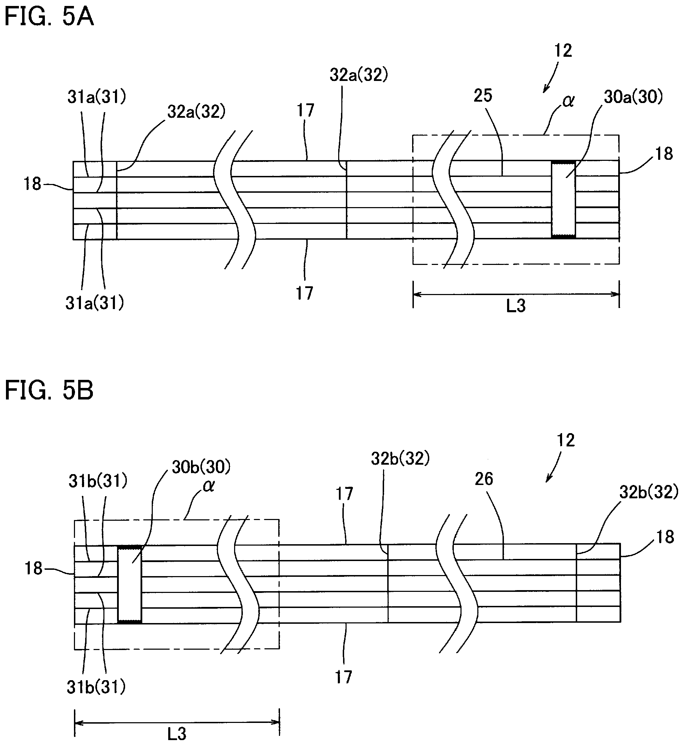

As shown in Fig. 5, the plan view shape of the solar cell 12 is a shape including two long sides 17 at positions facing each other and short sides 18 extending in a direction intersecting with the long sides 17. The solar cell 12 of the present embodiment has a substantially rectangular shape whose plan view shape extends in the predetermined direction, in which the two long sides 17 are parallel to each other and the two short sides 18 are orthogonal to the long sides 17.

It is preferable that the length of the long side 17 (longitudinal direction length) of the solar cell 12, when planarly viewed, is 5 times longer than and 100 times shorter than the length of the short side 18 (width direction length). In the solar cell 12 of the present embodiment, the length of the long side 17 is 25 times of a length of the short side 18, and its plan view shape is elongated.

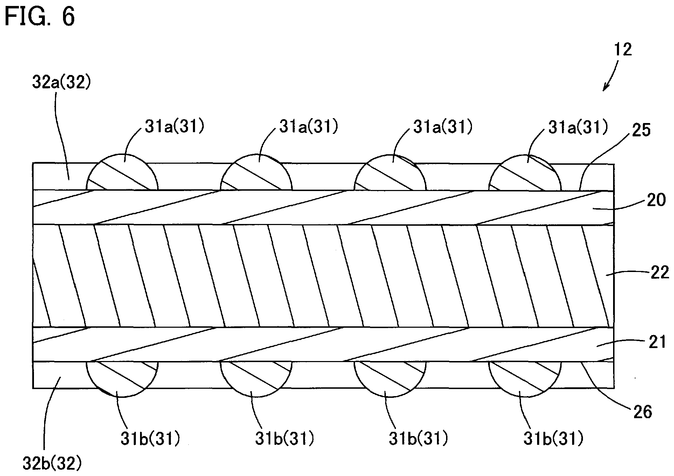

As shown in Fig. 6, the solar cell 12 has a pair of transparent electrode layers 20, 21 (a pair of cell electrode layers), and a photoelectric conversion part 22 is sandwiched by the pair of transparent electrode layers 20, 21.

The photoelectric conversion part 22 is a portion formed to include a semiconductor substrate and a semiconductor layer having an opposite conductivity type to that of the semiconductor substrate, and the part can convert light energy into electric energy.

As shown in Fig. 4, the solar cell 12 has a first main surface 25 constituting one end side in a thickness direction (vertical direction in Fig. 4) and a second main surface 26 constituting the other end side. The thickness direction means a direction orthogonal to each of the longitudinal direction and width direction of the solar cell 12.

In the solar cell 12, a first bus bar electrode 30a (connection electrode), a plurality of first finger electrodes 31a (first current collecting electrodes), and a plurality of first auxiliary electrodes 32a are provided on the first main surface 25, as shown in Fig. 5. In the solar cell 12, a second bus bar electrode 30b (connection electrode), a plurality of second finger electrodes 31b (second current collecting electrodes), and a plurality of second auxiliary electrodes 32b are provided on the second main surface 26. In the solar cell 12 of the present embodiment, four finger electrodes 31a and four finger electrodes 31b are provided.

The first finger electrodes 31a are arranged in parallel at intervals in the lateral direction (width direction) of the solar cell 12 to form an array of electrodes (hereinafter, also referred to as a second electrode array). Each of the first finger electrodes 31a extends, along the longitudinal direction of the solar cell 12, from one end side to the other end side in the longitudinal direction.

The first bus bar electrode 30a and the first auxiliary electrodes 32a extend in a direction intersecting with (direction orthogonal to) the longitudinal direction of the first finger electrode 31a, and are in contact with each of the first finger electrodes 31a.

All of the first bus bar electrode 30a and the first auxiliary electrodes 32a extend, between one end and the other end in the width direction (lateral direction) of the solar cell 12, to cross the second electrode array constituted by the plurality of first finger electrodes 31a.

The first bus bar electrode 30a and the respective first auxiliary electrodes 32a are disposed in parallel at intervals in the longitudinal direction of the solar cell 12, and form an array of electrodes (hereinafter, also referred to as a first electrode array).

In the first electrode array, the interval between the respective electrodes is larger than that in the second electrode array constituted by the first finger electrodes 31a.

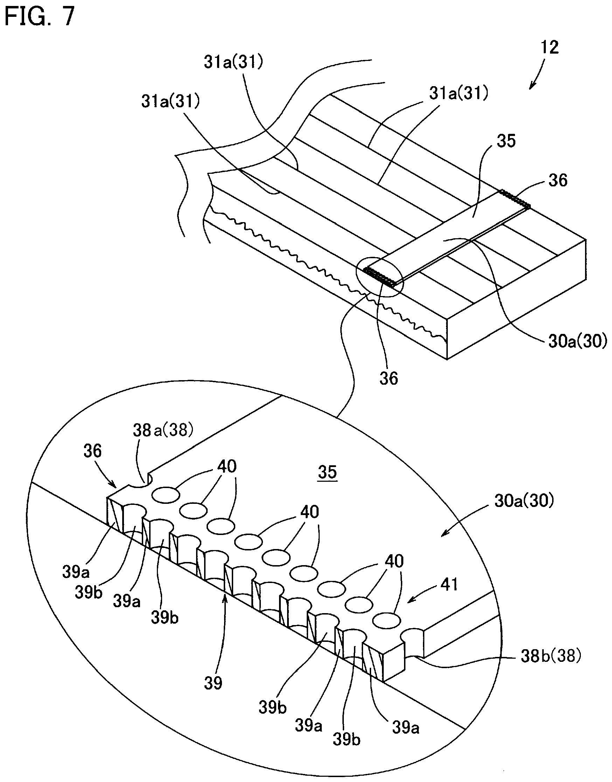

As shown in Fig. 7, the first bus bar electrode 30a is roughly partitioned into a central main body part 35 and end side portions 36.

The central main body part 3 5 is a portion located near the center (central side) in the width direction of the solar cell 12 (longitudinal direction of the first bus bar electrode 30a), and its plan view shape is a substantially rectangular plate shape (or a foil shape or film shape).

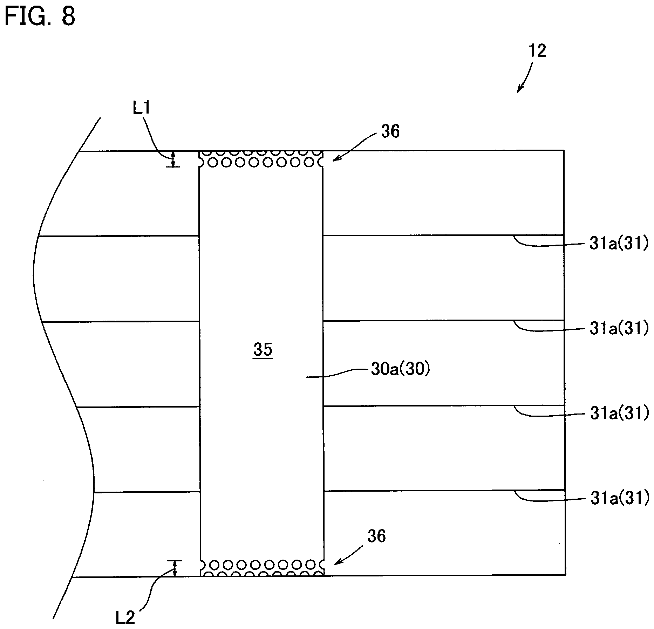

As shown in Fig. 8, the end side portion 36 is a portion forming the end and its peripheral portion in the width direction of the solar cell 12, and is a portion constituting a bus bar end.

The end side portions 36 are formed between the end of the first bus bar electrode 30a and a position away from the end by a predetermined distance L1, L2 in the longitudinal direction of the first bus bar electrode 30a. The predetermined distances L1, L2 may be the same as or different from each other. That is, the end side portions 36 on one side and the other side may be of the same size (of substantially the same size) or of different sizes.

In the end side portion 36, notches 38 (38a, 38b) (missing parts) each recessed from the end toward the center in the width direction of the first bus bar electrode 30a are provided as shown in Fig. 7. The surface located at the end in the longitudinal direction of the first bus bar electrode 30a is an end irregular surface part 39 that is a surface including irregularities. Additionally, a plurality of through hole parts 40 (through holes) are formed at positions slightly away from the ends toward the center in the longitudinal direction of the first bus bar electrode 30a.

The notches 38 are missing portions formed by missing the vicinities of the ends in the width direction of the first bus bar electrode 30a. The notch 38 of the present embodiment forms a curved surface that is rounded and convex toward the center in the width direction of the first bus bar electrode 30a.

As for the end irregular surface part 39, end surface parts 39a (cut surface parts, cut surfaces) located near the end and hole mark parts 39b (cut structure mark parts) recessed from the end toward the center (central side) are continuously formed in the longitudinal direction of the first bus bar electrode 30a.

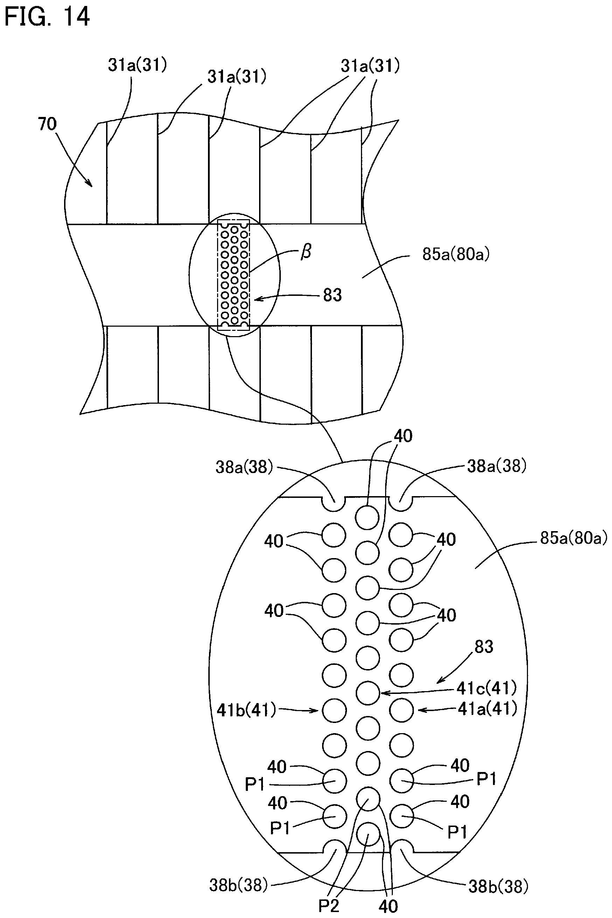

The end surface part 39a is a portion obtained by cutting a part of a low rigidity part 83 (see Fig. 14), and constitutes a part of the end surface. In the solar cell 12 of the present embodiment, the end surface is constituted by a plurality of the end surface parts 39a that are intermittent in the width direction of the first bus bar electrode 30a, and the plurality of the end surface parts 39a are arranged in a row at intervals in the same direction.

Specifically, as for the end irregular surface part 39, the end surface parts 39a and the hole mark parts 39b are alternately arranged from one end toward the other end in the width direction of the first bus bar electrode 30a. Therefore, a plurality of the hole mark parts 39b are disposed in a row at intervals in the width direction of the first bus bar electrode 30a, similarly to the plurality of the end surface parts 39a.

The hole mark part 39b is a portion that is recessed to be rounded and convex from the end toward the center (central side) in the longitudinal direction of the first bus bar electrode 30a. In other words, the hole mark part 39b is a portion that forms a curved surface curved such that its plan view shape is an arc shape, and in a raw material solar cell 70, it is also a portion that constituted a part of the through hole part 40 penetrating the first bus bar electrode 30a.

The through hole part 40 has a circular opening shape, and is a hole penetrating the first bus bar electrode 30a (end side portion 36).

A plurality of the through hole parts 40 of the present embodiment are arranged in a row at intervals between the two notches 38a, 38b formed at positions separated in the width direction of the first bus bar electrode 30a, thus forming a through hole row 41. The through hole row 41 is located closer to the center in the longitudinal direction of the first bus bar electrode 30a than a row formed by the plurality of the hole mark parts 39b.

Subsequently, the second main surface 26 side of the solar cell 12 will be described, but detailed description of the same portions as the first main surface 25 side will be omitted.

In the solar cell 12, the second bus bar electrode 30b, a plurality of (four in the present embodiment) second finger electrodes 31b, and a plurality of (two in the present embodiment) second auxiliary electrodes 32b are provided on the second main surface 26, as shown in Fig. 5B.

Each of the second finger electrodes 31b extends along the longitudinal direction of the solar cell 12.

The second bus bar electrode 30b and the second auxiliary electrodes 32b extend in a direction intersecting with (direction orthogonal to) the longitudinal direction of the second finger electrodes 31b, and are in contact with each of the second finger electrodes 31b.

As shown in Fig. 6, the same number of the second finger electrodes 31b as that of the first finger electrodes 31a are provided, and they extend in the same direction as the first finger electrodes 31a. Each of the second finger electrodes 31b overlaps with the first finger electrode 31a in the thickness direction of the solar cell 12 (vertical direction in Fig. 6).

The second finger electrode 31b of the present embodiment has the same (or substantially the same) width direction length as that of the first finger electrode 31a, and is formed such that the entire areas (or substantially entire areas) in the width direction of both the finger electrodes 31a, 31b overlap with each other in the thickness direction of the solar cell 12 (plan view). In other words, the solar cell 12 is formed such that at least a part of the second finger electrode 31b and at least a part of the first finger electrode 31a overlap with each other in plan view.

The second finger electrode 31b extends, in plan view, in the same direction as the first finger electrode 31a, and preferably overlaps with most of the first finger electrode 31a. The second finger electrode 31b more preferably overlaps with 80% or more of the first finger electrode 31a, and particularly preferably overlaps with 90% or more of the first finger electrode 31a.

As shown in Figs. 5A and 5B, the first auxiliary electrodes 32a and the second auxiliary electrodes 32b are formed not to overlap each other in the thickness direction of the solar cell 12.

As shown in Fig. 5A, the first auxiliary electrodes 32a are provided in the longitudinal middle part of the solar cell 12. Specifically, they are formed at a position slightly away from one end (left end in Fig. 5) toward the center (central side) in the longitudinal direction of the solar cell 12 and a position near the center (central position) in the longitudinal direction.

As shown in Fig. 5B, the second auxiliary electrodes 32b are provided in the longitudinal middle part of the solar cell 12. Specifically, they are formed at a position slightly away from the other end (right end in Fig. 5) toward the center (central side) in the longitudinal direction of the solar cell 12 and a position away from a position near the center (central position) toward the other end in the longitudinal direction.

The first bus bar electrode 30a is provided near one end (right end side in Fig. 5) in the longitudinal direction of the solar cell 12, while the second bus bar electrode 30b is provided near the other end (left end side in Fig. 5) in the longitudinal direction.

That is, both the bus bar electrodes 30a, 30b are configured to be provided on the end sides (positions near the ends) in the longitudinal direction of the solar cell 12, and to be formed neither at the center (central position) nor near the center (central position) in the longitudinal direction.

The term "(a thing) is provided near an end" used here means that on each of the first main surface 25 and the second main surface 26 of the solar cell 12, when planarly viewed, (the thing) is provided in a region (end side region α) from an end to a position away from the end by a predetermined distance L3 in the longitudinal direction of the solar cell 12.

The predetermined distance L3 is 20% or less of the total length (longitudinal direction length) of the solar cell 12, more preferably 15% or less, and even more preferably 5% or less.

The bus bar electrodes 30 (30a, 30b) are electrodes having a longer width direction length (thicker) than those of the finger electrodes 31 (31a, 31b) and the auxiliary electrodes 32 (32a, 32b).

The auxiliary electrodes 32 of the present embodiment have the same width direction length as that of the finger electrode 31.

Alternatively, the auxiliary electrodes 32 may be formed such that the width direction length is longer (thicker) than that of the finger electrode 31, or may be formed such that the width direction length is shorter (thinner) than that of the finger electrode 31.

The longitudinal side surface of the solar cell 12, which is continuous with each of the first main surface 25 and the second main surface 26, has a laser processing region 43 and a folding region 44, as shown in Fig. 4.

In the solar cell 12 of the present embodiment, the laser processing region 43 is formed at a position near the second main surface 26, while the folding region 44 is formed at a position near the first main surface 25.

The laser processing region 43 is a region having a larger surface roughness than the folding region 44.

Here, the laser processing region 43 has a tip side region 43a located near the first main surface 25 and a base side region 43b located near the second main surface 26.

The tip side region 43a has a sawtooth shape in side view. That is, the boundary portion between the laser processing region 43 and the folding region 44 has a linear shape extending by being folded back multiple times. Therefore, in the portion where the tip side region 43a is located, the portion to be the laser processing region 43 and the portion to be the folding region 44 are adjacent in the longitudinal direction of the solar cell 12.

The base side region 43b becomes the laser processing region 43 over the entire area in the longitudinal direction of the solar cell 12. In the base side region 43b, a length L4 in the thickness direction of the solar cell 12 is preferably 40% or less of the thickness (thickness direction length) of the solar cell 12.

As shown in Figs. 2 and 3, the solar cell module 1 includes, as the wiring members 13, the first extraction wire 50, the second extraction wire 51, first interconnectors 52, second interconnectors 53, and connecting wires 54.

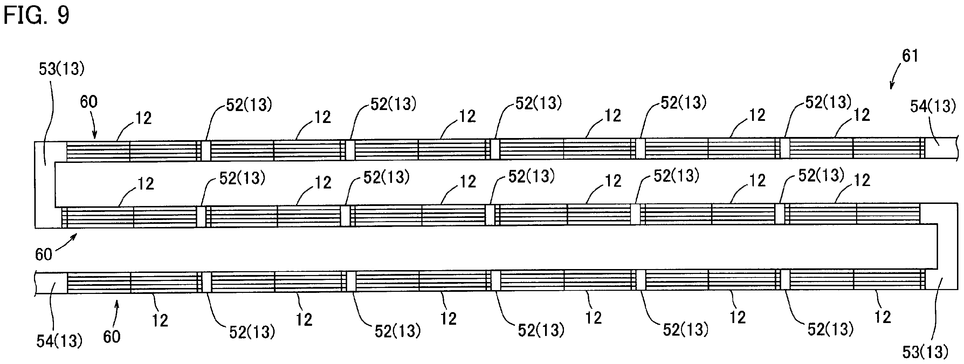

In the solar cell module 1 of the present embodiment, a plurality of (six in the present embodiment) the solar cells 12 are linearly arranged in a row, and the adjacent solar cells 12 are electrically connected in series by the first interconnector 52 to form a cell row 60 (see Figs. 2 and 9).

In the solar cell module 1, a plurality of (three in the present embodiment) the cell rows 60 are further electrically connected in series by the second interconnectors 53 to form a cell array assembly 61 (cell group) (see Figs. 2 and 9).

Moreover, In the solar cell module 1, one of the positive electrode and the negative electrode of the cell array assembly 61 is electrically connected to the first extraction wire 50 by the connecting wire 54, and the other electrode is electrically connected to the second extraction wire 51 by the connecting wire 54 (see Fig. 2).

As described above, the first interconnector 52 is a member (tab line) for electrically connecting two solar cells 12a, 12b belonging to the cell row 60 and disposed at adjacent positions.

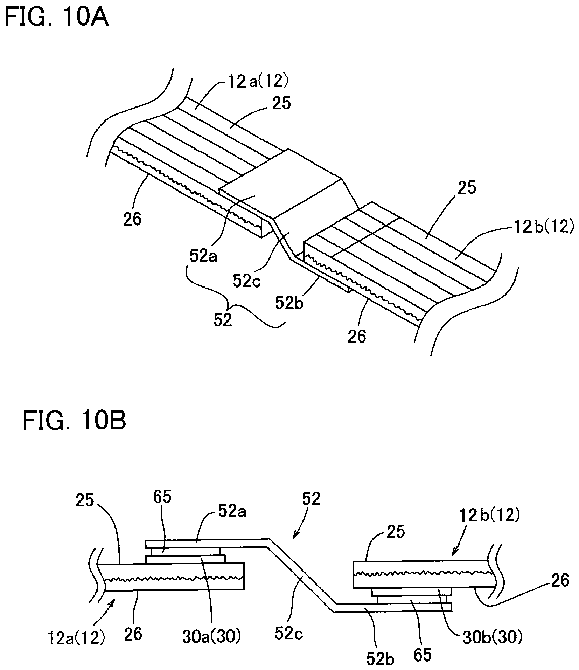

The first interconnector 52 is plate-shaped (or foil-shaped or film-shaped), in which the overall shape thereof extends so as to have substantially a Z-shape, as shown in Fig. 10.

The first interconnector 52 has a first cover part 52a, a second cover part 52b, and a connecting part 52c that connects the cover parts 52a, 52b.

The first cover part 52a is a portion that spreads planarly and covers a part of the first main surface 25 of the solar cell 12a on one side. The first cover part 52a is connected to the first bus bar electrode 30a of the solar cell 12a on the one side via a conductive adhesive 65.

The second cover part 52b is a portion that spreads planarly and covers a part of the second main surface 26 of the solar cell 12b on the other side. The second cover part 52b is a portion to be connected to the second bus bar electrode 30b of the solar cell 12b on the other side via the conductive adhesive 65.

Each of the cover parts 52a, 52b is disposed such that at least a part thereof overlaps with a part of the solar cell 12a, 12b in the thickness direction of the solar cell 12.

The connecting part 52c is a portion extending in a direction including a row direction component of the cell row 60 (see Figs. 2, 9, etc.) and a thickness direction component of the solar cell 12, and its one end is continuous with the first cover part 52a and the other end is continuous with the second cover part 52b.

The second interconnector 53 is a member (tab line) for electrically connecting one solar cell 12c belonging to one cell row 60 and one solar cell 12d belonging to another cell row 60, as shown in Figs. 2, 9, and 11. The second interconnector 53 is a plate-shaped (or foil-shaped or film-shaped) member extending in a substantially U-shape in plan view with the thickness direction of the module main body 3 as a line-of-sight direction.

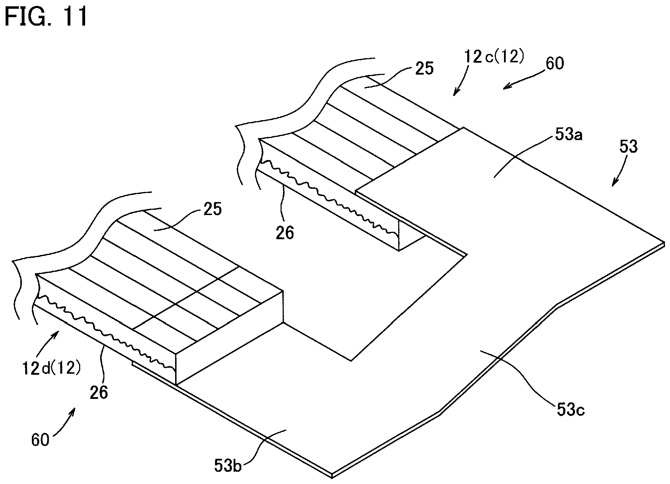

Specifically, the second interconnector 53 has a first cover part 53a that covers a part of the first main surface 25 of one solar cell 12c, a second cover part 53b that covers a part of the second main surface 26 of another solar cell 12d, and a connecting part 53c that connects them, as shown in Fig. 11.

The first cover part 53a and the second cover part 53b extend in the same direction as the longitudinal direction of the solar cell 12 (row direction of the cell row 60).

The first cover part 53a and the second cover part 53b are integrally connected to the first bus bar electrode 30a of one solar cell 12c and the second bus bar electrode 30b of the other solar cell 12d via the conductive adhesive 65, respectively, similarly to the first cover part 52a and the second cover part 52b described above (see Fig. 10B).

In the solar cell module 1 of the present embodiment, the first extraction wire 50, the second extraction wire 51, a part of the second interconnector 53 (a portion corresponding to the connecting part 53c, see Fig. 11), and a part of the connecting wire 54 connected thereto are located inside the frame member 4, as shown in Fig. 2.

That is, in the solar cell module 1, they are sealed inside the edge of the module main body 3, and the edge portion of the module main body 3 is located inside the frame member 4.

In the solar cell module 1, a center side portion 3a of the module main body 3, that is exposed to the outside of the frame member 4, has a state in which the cell rows 60 are arranged in parallel at intervals in a predetermined direction (vertical direction in Fig. 2). In this case, a part of the second interconnector 53 or a part of the connecting wire 54 extends, at both end portions in the longitudinal direction of each cell row 60 (line-up direction of the row, which is the left-right direction in Fig. 2).

That is, in the solar cell module 1, a linearly extending structure is formed inside the center side portion 3a by the cell row 60 and a part of the wiring member 13 (a part of the second interconnector 53 or a part of the connecting wire 54) located at both ends in the line-up direction of the cell row 60. The structure extends from one end to the other end of the center side portion 3a in the line-up direction of the cell row 60 (left-right direction in Fig. 2).

The structures are arranged in parallel at intervals in a direction intersecting with the longitudinal direction of the cell row 60 (In the present embodiment, a direction orthogonal to the longitudinal direction, which is the vertical direction in Fig. 2.). From this, when the solar cell module 1 of the present embodiment is used as a window, a texture as if it were a blind can be exhibited by light entering from between the respective structures.

Subsequently, a method for manufacturing the solar cell module 1 of the present embodiment will be described.

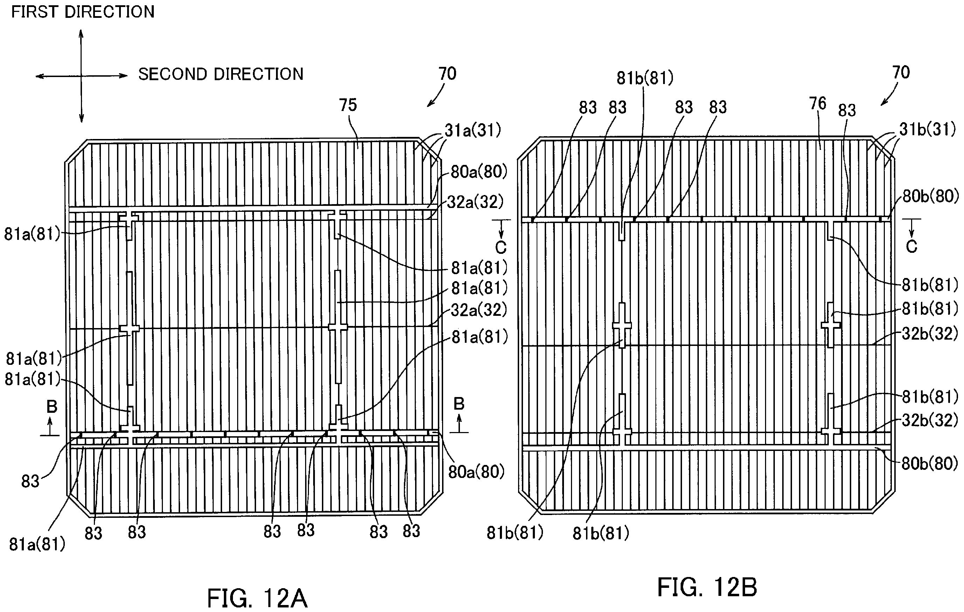

In the method for manufacturing the solar cell module 1 of the present embodiment, a raw material cell manufacturing step of manufacturing the raw material solar cell 70 (see Fig. 12) is firstly and a cell dividing step of dividing the raw material solar cell 70 into a plurality of pieces is sequentially performed, whereby the solar cells 12 are manufactured.

If necessary, before the cell dividing step, a confirmation step of confirming whether the raw material solar cell 70 normally performs photoelectrical conversion may be performed by connecting an external load to the raw material solar cell 70. This makes it possible to confirm whether the raw material solar cell 70 is a defective product or not for further improvement of the yield.

Subsequently, a plurality of the solar cells 12 manufactured and the wiring members 13 are sealed between the first transparent substrate 10 and the second transparent substrate 11 to manufacture the module main body 3 (see Fig. 3). Then, the terminal box 5 is attached to the module main body 3, and the frame member 4 is further attached to form the solar cell module 1.

Hereinafter, the raw material cell manufacturing step and the cell dividing step, which are one of the features of the present embodiment, will be described in detail.

The raw material cell manufacturing step is a step of manufacturing the raw material solar cell 70 that can be used as an ordinary solar cell.

In the raw material solar cell 70, various electrodes are formed by printing a conductive paste on the main surface of the solar cell substrate, and drying and firing the conductive paste, similarly to ordinary solar cells.

The conductive paste is prepared by blending a solvent, a resin, a dispersant, and the like with conductive metal powder such as silver powder or copper powder.

As shown in Fig. 12, the raw material solar cell 70 is a quadrangular plate with four corners missing in plan view. That is, the raw material solar cell 70 is a solar cell having a substantially rectangular plate shape.

The raw material solar cell 70 has a first main surface 75 constituting one end side in the thickness direction (see Fig. 12A), and a second main surface 76 constituting the other end side (see Fig. 12B).

In the raw material solar cell 70, the first finger electrodes 31a (first current collecting electrodes), the first auxiliary electrodes 32a, the first bus bar electrodes 80a (first connection electrode formation parts), and first auxiliary bus bar electrodes 81a are provided on the first main surface 75, as shown in Fig. 12.

In the raw material solar cell 70, the second finger electrodes 31b (second current collecting electrodes), the second auxiliary electrodes 32b, second bus bar electrodes 80b (second connection electrode formation parts), and second auxiliary bus bar electrodes 81b are provided on the second main surface 76.

As described above, the auxiliary electrodes 32a, 32b are thicker (longer in the width direction length) electrodes than the finger electrodes 31a, 31b.

The bus bar electrodes 80a, 80b and the auxiliary bus bar electrodes 81a, 81b are electrodes further thicker than the auxiliary electrodes 32a, 32b.

In the raw material solar cell 70, a plurality of the first finger electrodes 31a are provided to extend in a predetermined direction, as shown in Fig. 12A.

In the following description, the extending direction of the first finger electrodes 31a is also referred to as a first direction, while the direction intersecting with (orthogonal to) the first direction is also referred to as a second direction.

The respective first finger electrodes 31a are arranged in parallel at intervals in the second direction. The electrode rows by the first finger electrodes 31a are formed over substantially the entire area of the first main surface 75 except for a part including the peripheral edge portion of the first main surface 75.

The first auxiliary electrodes 32a are electrodes extending in the second direction, and have a length slightly shorter than the length in the second direction of the raw material solar cell 70. That is, the first auxiliary electrodes 32a extend, in the second direction, from a position slightly away from one end of the raw material solar cell 70 to a position slightly away from the other end.

The first bus bar electrodes 80a are electrodes extending in the second direction, and have a length slightly shorter than the length in the second direction of the raw material solar cell 70.

Here, a plurality of the first auxiliary electrodes 32a and a plurality of the first bus bar electrodes 80a are provided, and they are arranged in parallel at intervals in the first direction. That is, these electrodes 32a, 80a extend to be parallel to each other, and form an electrode array arranged in parallel at intervals in the first direction. In this electrode array, the interval between the respective electrodes is larger than that in the electrode array constituted by the plurality of the first finger electrodes 31a.

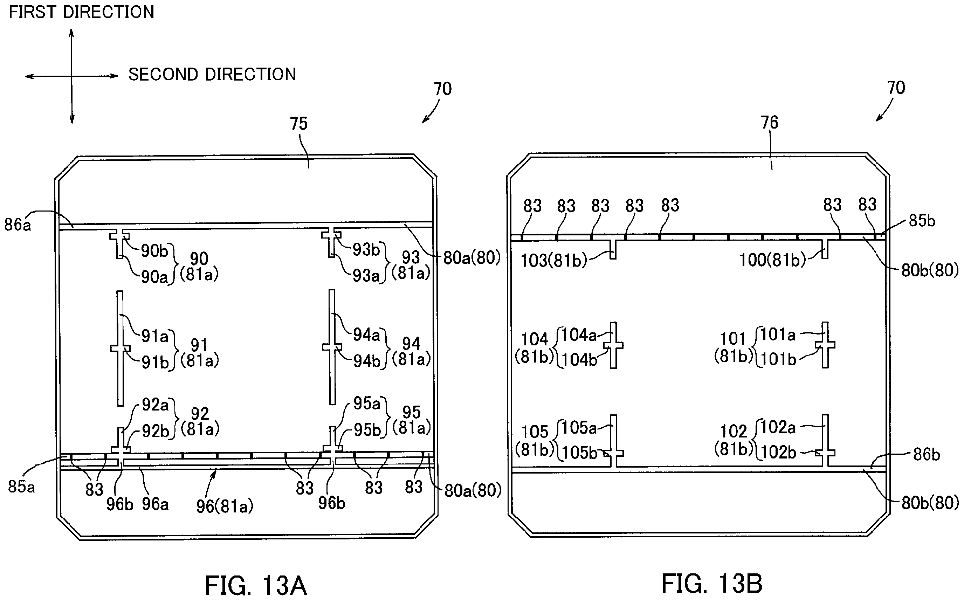

Here, among the first bus bar electrodes 80a, one first bus bar electrode 80a (hereinafter, also referred to as a product bus bar electrode 85a) is provided with the low rigidity parts 83 (cutting regions) at a plurality of places, and the other first bus bar electrode 80a (hereinafter, also referred to as a non-product bus bar electrode 86a) is provided with no low rigidity part 83 (see Figs. 12A, 13A, etc.).

Specifically, in the product bus bar electrode 85a, a plurality of the low rigidity parts 83 are arranged in a row at intervals along the longitudinal direction of the product bus bar electrode 85a (second direction), and each low rigidity part 83 is a portion having a lower rigidity than the other parts.

The product bus bar electrode 85a of the present embodiment has, in a part thereof, a portion where the interval between the two low rigidity parts 83 is larger than the other portions, in the row of the low rigidity parts 83 formed by arranging the plurality of the low rigidity parts 83 in a row. However, the row of the low rigidity parts 83 may be formed such that all the intervals between the two low rigidity parts 83 are equal to each other.

As shown in Fig. 14, the low rigidity part 83 of the present embodiment is formed by providing a plurality of the notches 38 and a plurality of the through hole parts 40 in a predetermined region (region indicated by β in the view) of the product bus bar electrode 85a.

The notch 38 is a portion formed by missing the end in the width direction of the product bus bar electrode 85a, which forms a recessed curved surface that is rounded and convex toward the center in the width direction. The notch 38 is formed to penetrate the product bus bar electrode 85a in the thickness direction (depth direction in Fig. 14), between one end and the other end in the thickness direction.

In the product bus bar electrode 85a of the present embodiment, a plurality of (two) notches 38 are arranged in a row at intervals in the width direction of the first bus bar electrode 80a (vertical direction in Fig. 14). Additionally, in the product bus bar electrode 85a, a plurality of (two) notches 38 are arranged in a row at intervals in the longitudinal direction of the first bus bar electrode 80a (left-right direction in Fig. 14).

The through hole part 40 has a circular opening shape, and is a through hole penetrating the first bus bar electrode 80a in the thickness direction.

In the product bus bar electrode 85a, a plurality of (three in the present embodiment) through hole rows 41a, 41b, 41c, which are formed by arranging a plurality of the through hole parts 40 in rows in the width direction of the product bus bar electrode 85a, are formed, and these through hole rows 41a, 41b, 41c are arranged in parallel in the longitudinal direction of the product bus bar electrode 85a.

The first through hole row 41a and the second through hole row 41b are formed between the two notches 38a, 38b respectively located at both ends in the width direction of the product bus bar electrode 85a (vertical direction in Fig. 14).

In the product bus bar electrode 85a, the third through hole row 41c is provided between the first through hole row 41a and the second through hole row 41b.

The third through hole row 41c has a larger number of the through hole parts 40 than the through hole rows 41a, 41b. Opening centers P1 of the through hole parts 40 belonging to the first through hole row 41a and the second through hole row 41b and opening centers P2 of the through hole parts 40 belonging to the third through hole row 41c are located at positions shifted (different) from each other in the width direction of the product bus bar electrode 85a (vertical direction in Fig. 14).

As shown in Fig. 13A, the first auxiliary bus bar electrodes 81a are constituted by a first small electrode part 90, a second small electrode part 91, a third small electrode part 92, a fourth small electrode part 93, a fifth small electrode part 94, a sixth small electrode part 95, and a seventh small electrode part 96, which are formed at positions separated from each other.

The first small electrode part 90 is a portion whose plan view shape extends in a substantially cross shape, and is formed by integrating a first extending part 90a extending in the first direction and a second extending part 90b extending in the second direction.

The second small electrode part 91 and the third small electrode part 92 are portions whose plan view shapes extend in a substantially cross shape, and have first extending parts 91a, 92a and second extending parts 91b, 92b. The first extending parts 91a, 92a and the second extending parts 91b, 92b extend in the same directions as the first extending part 90a and second extending part 90b of the first small electrode part 90, respectively.

The fourth small electrode part 93, the fifth small electrode part 94, and the sixth small electrode part 95 have the same shapes as those of the first small electrode part 90, the second small electrode part 91, and the third small electrode part 92, respectively, and redundant descriptions thereof will be omitted. The small electrode parts 93 to 95 have first extending parts 93a, 94a, 95a and second extending parts 93b, 94b, 95b, respectively.

The seventh small electrode part 96 has a main body part 96a extending in the second direction and a plurality of (two) connecting parts 96b extending in a direction intersecting with (orthogonal to) the main body part 96a.

The main body part 96a is a portion having the same (substantially the same) length as the first bus bar electrode 80a (product bus bar electrode 85a), and is provided at a position away from the first bus bar electrode 80a (product bus bar electrode 85a) toward one side in the first direction (lower side in Fig. 13).

The connecting parts 96b are formed at positions separated from each other in the second direction, and both extend between the main body part 96a and the first bus bar electrode 80a (product bus bar electrode 85a) to connect them. That is, one end in the extending direction (first direction) of the connecting part 96b is in contact with the main body part 96a, and the other end is in contact with the first bus bar electrode 80a (product bus bar electrode 85a).

Here, one end (upper side in Fig. 13A) in the longitudinal direction (first direction) of the first extending part 90a, 93a of each of the first small electrode part 90 and the fourth small electrode part 93 is in contact with one first bus bar electrode 80a (non-product bus bar electrode 86a). The other end (lower side in Fig. 13A) in the longitudinal direction (first direction) of the first extending part 92a, 95a of each of the third small electrode part 92 and the sixth small electrode part 95 is in contact with the other first bus bar electrode 80a (product bus bar electrode 85a).

The first extending parts 90a, 91a, 92a of the small electrode parts 90 to 92 and one connecting part 96b are linearly arranged in a row at intervals in the first direction.

Similarly, the first extending parts 93a, 94a, 95a of the small electrode parts 93 to 95 and the other connecting part 96b are linearly arranged in a row at intervals in the first direction.

The small electrode parts 90 to 92 and the small electrode parts 93 to 95 are formed at positions separated from each other in the second direction, respectively.

Subsequently, the second main surface 76 side of the raw material solar cell 70 will be described, but detailed description of the same portions as those of the first main surface 75 side will be omitted.

On the second main surface 76 of the raw material solar cell 70, a plurality of the second finger electrodes 31b are formed over substantially the entire area of the second main surface 76, and each of them extends in the first direction, as shown in Fig. 12B. The second auxiliary electrodes 32b and the second bus bar electrodes 80b extend in the second direction, respectively, and have a length slightly shorter than the length in the second direction of the raw material solar cell 70.

Among a plurality of the second bus bar electrodes 80b, one second bus bar electrode 80b (hereinafter, also referred to as a product bus bar electrode 85b) is provided with the low rigidity parts 83 at a plurality of places, as shown in Figs. 12B and 13B. The plurality of the low rigidity parts 83 are each arranged in a row at intervals along the longitudinal direction of the product bus bar electrode 85b.

As shown in Fig. 13B, the second auxiliary bus bar electrodes 81b are constituted by a first small electrode part 100, a second small electrode part 101, a third small electrode part 102, a fourth small electrode part 103, a fifth small electrode part 104, and a sixth small electrode part 105, which are formed at positions separated from each other.

The first small electrode part 100 and the fourth small electrode part 103 extend in the first direction.

The second small electrode part 101, the third small electrode part 102, the fifth small electrode part 104, and the sixth small electrode part 105 are portions whose plan view shapes extend in a substantially cross shape. That is, they are formed by integrating first extending parts 101a, 102a, 104a, 105a extending in the first direction and second extending parts 101b, 102b, 104b, 105b extending in the second direction, respectively.

One end (upper side in Fig. 13) in the longitudinal direction (first direction) of each of the first small electrode part 100 and the fourth small electrode part 103 is in contact with one second bus bar electrode 80b (product bus bar electrode 85b).

The other end (lower sides in Fig. 13) in the longitudinal direction (first direction) of the first extending part 102a, 105a of each of the third small electrode part 102 and the sixth small electrode part 105 is in contact with the other second bus bar electrode 80b (non-product bus bar electrode 86b).

The first small electrode part 100, the first extending part 101a of the second small electrode part 101, and the first extending part 102a of the third small electrode part 102 are linearly arranged in a row at intervals in the first direction.

Similarly, the fourth small electrode part 103, the first extending part 104a of the fifth small electrode part 104, and the first extending part 105a of the sixth small electrode part 105 are linearly arranged in a row at intervals in the first direction.

The small electrode parts 100 to 102 and the small electrode parts 103 to 105 are formed at positions separated from each other in the second direction, respectively.

Here, when the electrodes on the first main surface 75 side and the electrodes on the second main surface 76 side are compared, each of the first finger electrodes 31a and each of the second finger electrodes 31b are provided at positions overlapping each other in plan view (thickness direction of the raw material solar cell 70), as shown in Figs. 12A and 12B.

The first auxiliary electrodes 32a are provided at positions not overlapping any of the second auxiliary electrodes 32b in the thickness direction of the solar cell 12, as shown in Fig. 12.

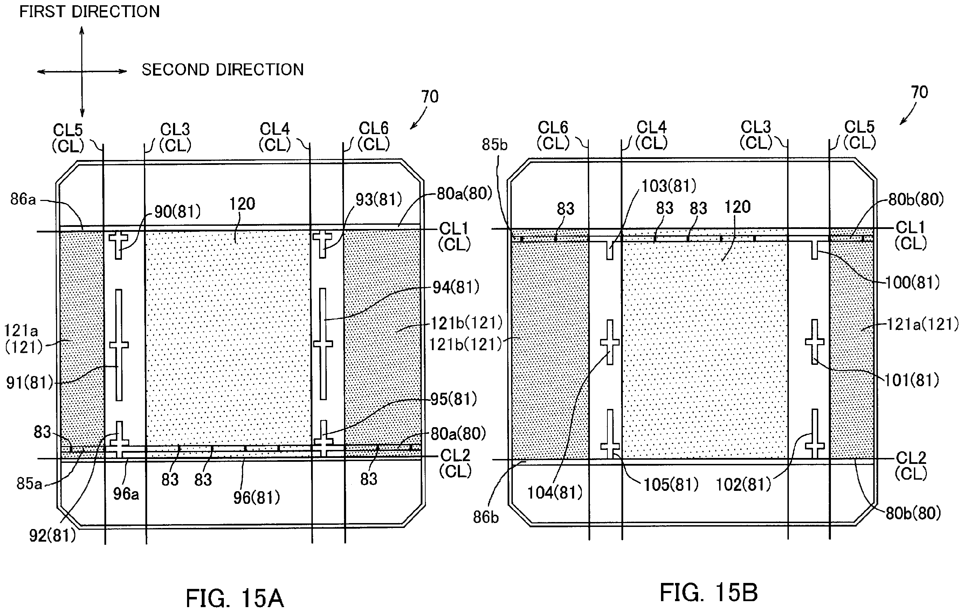

Further, the first small electrode part 90 on the first main surface 75 side is provided, as shown in Fig. 13, at a position where at least a part thereof overlaps the first small electrode part 100 on the second main surface 76 side in plan view (thickness direction of the raw material solar cell 70) (see Fig. 15, etc.). At least parts of the small electrode parts 91, 92 are provided at positions overlapping the small electrode parts 101,102 in plan view, respectively.

Similarly, at least parts of the small electrode parts 93 to 95 on the first main surface 75 side are provided at positions overlapping the small electrode parts 103 to 105 on the second main surface 76 side in plan view, respectively.

The first bus bar electrodes 80a on the first main surface 75 side are provided at positions not overlapping the second bus bar electrodes 80b on the second main surface 76 side in the thickness direction of the solar cell 12, respectively.

Specifically, when attention is paid to the non-product bus bar electrode 86a and the product bus bar electrode 85b located near one side in the first direction (upper side in Fig. 13), these two bus bar electrodes 86a, 85b are formed at positions separated from each other in the first direction.

The bus bar electrodes 85a, 86b formed at positions separated from the two bus bar electrodes 86a, 85b in the first direction and located near the other side in the first direction (lower side in Fig. 13) are formed at positions separated from each other in the first direction, respectively.

In the raw material solar cell 70 of the present embodiment, a first raw material part 120 located near the center of the raw material solar cell 70 and two second raw material parts 121a, 121b located outside the first raw material part 120 in the second direction are used to manufacture the solar cell 12 (see Fig. 15). In other words, the other portions excluding the first raw material part 120 and the second raw material parts 121a, 121b are remaining portions that are not used for manufacturing the solar cell 12. That is, in the cell dividing step of the present embodiment, a part of the raw material solar cell 70 is only used for manufacturing the solar cell 12.

As shown in Fig. 15, the first raw material part 120 is a portion surrounded by four dividing lines CL1 to CL4.

Here, dividing lines CL are portions serving as boundaries when the raw material solar cell 70 is divided into a plurality of small pieces.

The dividing lines CL1, CL2 each extend in the second direction, and are located at positions separated from each other in the first direction.

The dividing line CL1 extends between the non-product bus bar electrode 86a that is located near one end in the first direction (upper side in Fig. 15) and the product bus bar electrode 85b. That is, the dividing line CL1 is located on the inner side (near the other end) of the non-product bus bar electrode 86a and on the outer side (near the one end) of the product bus bar electrode 85b.

The dividing line CL2 extends between the product bus bar electrode 85a that is located near the other end in the first direction (lower side in Fig. 15) and the non-product bus bar electrode 86b. That is, the dividing line CL2 is located on the outer side (near the one end) of the product bus bar electrode 85a and on the inner side (near the other end) of the non-product bus bar electrode 86b.

Additionally, the dividing line CL2 is located near the one end (upper end side in Fig. 15) of the main body part 96a of the seventh small electrode part 96.

The dividing lines CL3, CL4 each extend in the first direction, and are located at positions separated from each other in the second direction.

The dividing line CL3 extends, on the first main surface 75 side, at a position closer to the center of the raw material solar cell 70 in the second direction than each of the small electrode parts 90 to 92 is (see Fig. 15A). Additionally, the dividing line CL3 extends, on the second main surface 76 side, at a position closer to the center of the raw material solar cell 70 in the second direction than the small electrode parts 100 to 102 are (see Fig. 15B).

The dividing line CL4 extends at a position close to each of the small electrode parts 93 to 95, the position being closer to the center of the raw material solar cell 70 in the second direction than these electrodes are.

Additionally, the dividing line CL4 extends, on the second main surface 76 side, at a position close to each of the small electrode parts 103 to 105, the position being closer to the center (inner side) of the raw material solar cell 70 in the second direction than these three small electrode parts 103 to 105 are.

From the above, the first raw material part 120 has a structure in which, between the two bus bar electrodes 85a, 86a on the first main surface 75 side, a part of the product bus bar electrode 85a is only included and the non-product bus bar electrode 86a is not included, as shown in Fig. 15A.

Additionally, the first raw material part 120 has a structure in which, between the two bus bar electrodes 85b, 86b on the second main surface 76 side, a part of the product bus bar electrode 85b is only included and the non-product bus bar electrode 86b is not included.

In this case, both the product bus bar electrodes 85a, 85b included in the first raw material part 120 become the bus bar electrodes 80a, 80b in each of which the low rigidity parts 83 are formed. The first raw material part 120 has a structure in which the auxiliary bus bar electrode 81 is included on neither the first main surface 75 side nor the second main surface 76 side.

As shown in Fig. 15, the second raw material part 121a is a portion surrounded by three dividing lines CL1, CL2, CL5 (or CL6), while the second raw material part 121b is a portion surrounded by three dividing lines CL1, CL2, CL6.

The dividing lines CL5, CL6 each extend in the first direction, and are located at positions separated form each other in the second direction.

The dividing line CL5 extends, on the first main surface 75 side, at a position adjacent to each of the small electrode parts 90 to 92. In detail, the dividing line CL5 extends at a position closer to the outside of the raw material solar cell 70 in the second direction than these three small electrode parts 90 to 92 are. Additionally, the dividing line CL5 extends, on the second main surface 76 side, at a position adjacent to each of the small electrode parts 100 to 102, the position being closer to the outside of the raw material solar cell 70 in the second direction than these three small electrode parts 100 to 102 are.

The dividing line CL6 extends, on the first main surface 75 side, at a position closer to the outside of the raw material solar cell 70 in the second direction than the small electrode parts 93 to 95 are. Additionally, the dividing line CL6 extends, on the second main surface 76 side, at a position closer to the outside of the raw material solar cell 70 in the second direction than the small electrode parts 103 to 105 are.

Therefore, the second raw material parts 121a, 121b have a structure in which, between the two bus bar electrodes 85a, 86a on the first main surface 75 side, a part of the product bus bar electrode 85a on one side in the first direction (lower side in Fig. 15A) is included and the non-product bus bar electrode 86a on the other side is not included.

The second raw material parts 121a, 121b have a structure in which, between the two bus bar electrodes 85b, 86b on the second main surface 76 side, a part of the product bus bar electrode 85b on the other side in the first direction (upper side in Fig. 15B) is included and the non-product bus bar electrode 86b on the other side is not included.

The product bus bar electrodes 85a, 86a included in the second raw material parts 121a, 121b each become the bus bar electrodes 80a, 80b in each of which the low rigidity parts 83 are formed.

The second raw material parts 121a, 121b have a structure in which the auxiliary bus bar electrode 81 is included on neither the first main surface 75 side nor the second main surface 76 side.

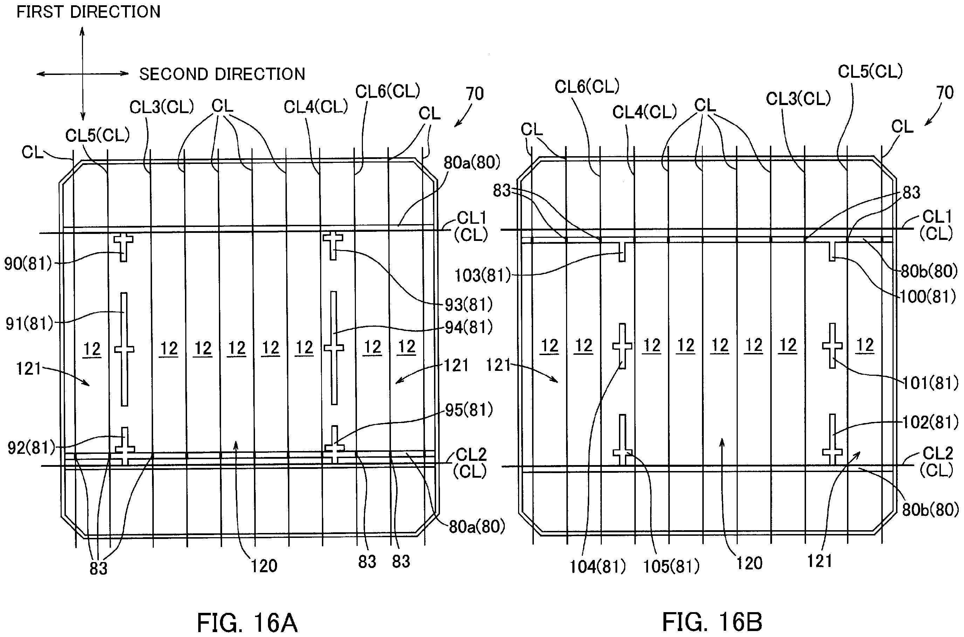

In the cell dividing step, the raw material parts 120, 121a, 121b are divided into strips along the respective dividing lines CL to form the solar cells 12, as shown in Fig. 16.

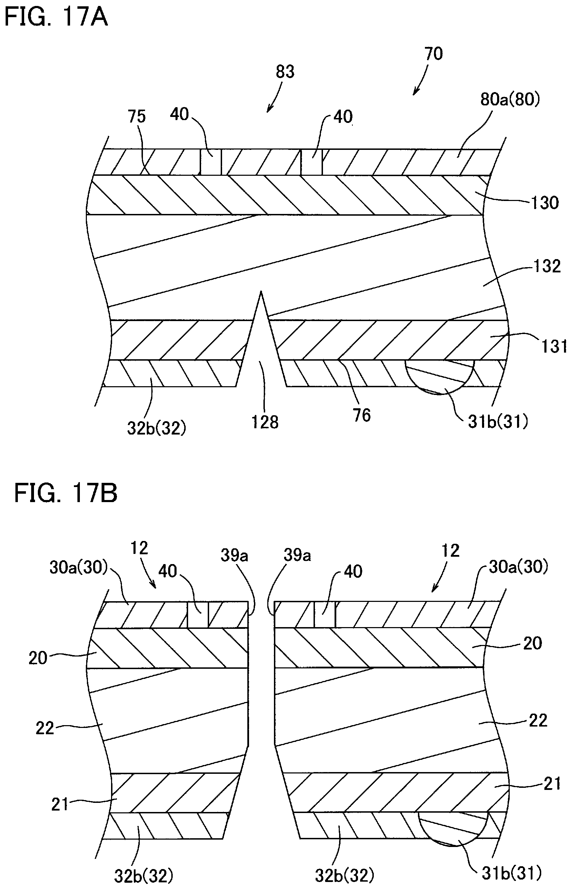

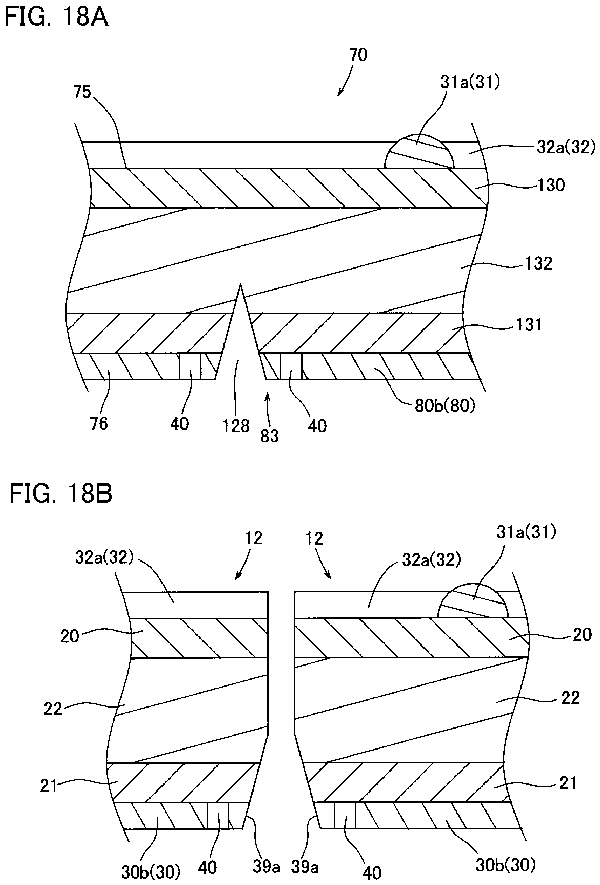

Here, in the cell dividing step of dividing the raw material solar cell 70, a laser processing step (see Figs. 17A and 18A) and a folding step are performed as shown in Figs. 17, 18.

The laser processing step is a step of emitting laser light from the second main surface 76 side of the raw material solar cell 70 to form a dividing groove 128 in the raw material solar cell 70 (see Figs. 17Aand 18A).

The dividing grooves 128 are grooves extending along the dividing lines CL (see Fig. 16 etc.), and have a depth of 40% or less of the thickness of the raw material solar cell 70.

The dividing groove 128 preferably cuts at least a part of the semiconductor substrate by reaching up to the semiconductor substrate forming the supporting substrate of the photoelectric conversion part 22.

By forming the dividing grooves 128 by laser processing in this way, the raw material solar cell 70 can be folded and cut.

The folding step is a step of folding the raw material solar cell 70 at the dividing groove 128 to cut it from the dividing groove 128 (see Figs. 17B and 18B).

As shown in Figs. 17A and 18A, the raw material solar cell 70 has a structure in which a pair of transparent electrode layers 130,131 (a pair of electrode layers) are included and a photoelectric conversion part 132 is sandwiched by the pair of transparent electrode layers 130,131.

In the raw material solar cell 70, the first transparent electrode layer 130, the second transparent electrode layer 131, and the photoelectric conversion part 132 are divided in the cell dividing step to become the first transparent electrode layer 20, second transparent electrode layer 21, and photoelectric conversion part 22 of the solar cell 12.

As shown in Figs. 12, 16, etc., the dividing lines CL extending in the first direction of the present embodiment extend at positions not overlapping, in plan view (thickness direction of the raw material solar cell 70), the finger electrodes 31 on the first main surface 75 side and the second main surface 76 side.

That is, In the cell dividing step, the finger electrodes 31 are not cut when the raw material solar cell 70 is cut along the dividing lines CL extending in the first direction.

In the present embodiment, laser light is emitted from the second main surface 76 side in the laser processing step, so that the respective electrodes formed on the second main surface 76 side are divided in the laser processing step.

That is, the second auxiliary electrode 32b (see Fig. 17A) and the second bus bar electrode 80b (see Fig. 18A) are cut by the dividing groove 128 extending along the dividing line CL extending in the first direction. The second finger electrodes 31b and the second auxiliary bus bar electrodes 81b are cut by the dividing grooves 128 extending along the dividing lines CL (dividing lines CL1, CL2) extending in the second direction (see Figs. 12, 16).

On the other hand, the respective electrodes formed on the first main surface 75 side are cut in the folding step.

When the raw material solar cell 70 is divided along the dividing line CL extending in the first direction (see Figs. 12, 16), the first auxiliary electrode 32a and the first bus bar electrode 80a are cut (see Figs. 17B and 18B). When the raw material solar cell 70 is divided along the dividing lines CL (dividing lines CL1, CL2) extending in the second direction, the first finger electrodes 31a and the first auxiliary bus bar electrodes 81a are cut (see Figs. 12, 16).

In the laser processing step, a part of the main body portion (portion including the first transparent electrode layer 130, the second transparent electrode layer 131, and the photoelectric conversion part 132) of the raw material solar cell 70 and the second bus bar electrode 80b are divided, as described above. That is, in the laser processing step, a portion including the second bus bar electrode 80b of the raw material solar cell 70 is cut (see Fig. 18A).

Then, in the folding step, a part of the main body portion of the raw material solar cell 70 and the first bus bar electrode 80a are divided. That is, in the folding step, a part including the first bus bar electrode 80a of the raw material solar cell 70 is cut (see Fig. 17A).

That is, the cell dividing step is a step of cutting the raw material solar cell 70 together with the bus bar electrodes 80a, 80b formed on the front and back surfaces, respectively.

From this, the end surface portions (end surface parts 39a, see Fig. 7, etc.) in the extending direction of the bus bar electrodes 30a, 30b of the solar cell 12 are each cut surfaces obtained by cutting the bus bar electrodes 80a, 80b of the raw material solar cell 70.

That is, the end surface in the extending direction of the first bus bar electrode 30a is a cut surface having a folded mark by the folding step, and the end surface in the extending direction of the second bus bar electrode 30b is a cut surface having a laser-processed mark by the laser processing step. That is, the shapes of the end surfaces of the bus bar electrodes 30a, 30b are different from each other.

In the laser processing step, the second bus bar electrode 80b may be cut such that the above end irregular surface part 39 (see Figs. 7, etc.) is formed at the end of the second bus bar electrode 30b. That is, in the laser processing step, the second bus bar electrode 80b may be cut such that the end surface parts 39a and the hole mark parts 39b, each continuous with the end surface part 39a, are formed at the end of the second bus bar electrode 30b.

On the other hand, in the laser processing step, the cutting width, obtained when the second bus bar electrode 80b is cut, may be increased by using laser with a large focus diameter, etc., and the third through hole row 41c (see Fig. 14) and its periphery of the second bus bar electrode 80b may be melted by the laser. In this case, the end irregular surface part 39 of the second bus bar electrode 30b may be configured to be formed only by the end surface parts 39a and not by the hole mark parts 39b.

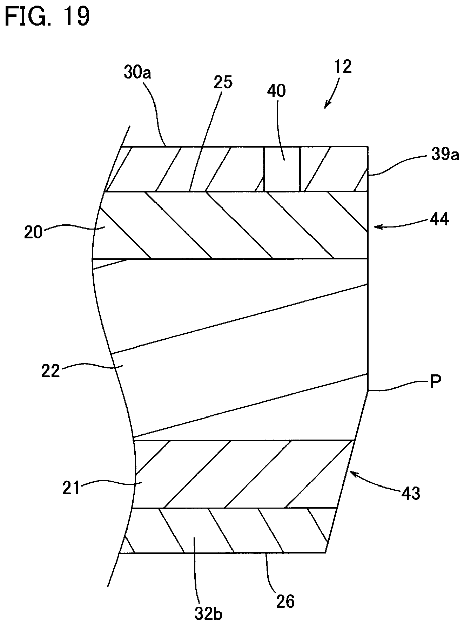

On the side surface of the solar cell 12, an inflection point P is formed, by the cell dividing step, at the boundary between the laser processing region 43 where a laser-processed mark melted by laser light is formed and the folding region 44 formed by the folding processing, as shown in Fig. 19.

That is, on the surfaces of the laser processing region 43 and the folding region 44, wavy irregular surfaces with peaks and valleys are formed in microscopic view, as shown in Fig.

20. The irregular surface of the laser processing region 43 is rougher than the irregular surface of the folding region 44.

As illustrated in Fig. 17 etc., the dividing groove 128 is a groove whose width gradually decreases as it goes toward the first main surface 75.

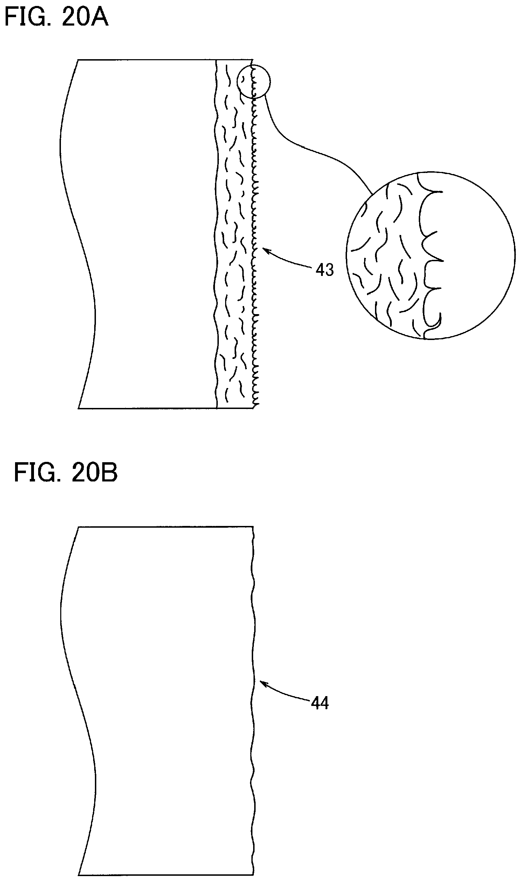

From the above, the inflection point P is formed at the boundary where the wavy irregular surface of the laser processing region 43 (see Fig. 20A) and the wavy irregular surface of the folding region 44 (see Fig. 20B) are continuous with each other, as shown in Fig. 19.

According to the method for manufacturing the solar cell module 1 of the present embodiment, the bus bar electrode 30 of the solar cell 12 is made thicker than other electrodes 31, 32, and the low rigidity parts 83 are formed in the bus bar electrode 80. So, even if the bus bar electrode 80 of the raw material solar cell 70 has a thickness that is difficult to cut, it can be easily cut by cutting the low rigidity parts 83. That is, according to the manufacturing method of the present embodiment, weak portions are intentionally provided in the bus bar electrode 80 of the raw material solar cell 70 and the weak portions are cut, so that cutting is easily performed.

According to the raw material solar cell 70 of the present embodiment, when the raw material solar cell 70 is planarly viewed, the first finger electrodes 31a on the first main surface 25 side and the second finger electrodes 31b on the second main surface 26 side extend in the same direction and most of them overlap each other, so that a large region where the finger electrodes 31a, 31b are not formed can be secured. Therefore, when the raw material solar cell 70 is divided, it can be easily cur by avoiding the finger electrodes 31a, 31b, so that a cell dividing step can be facilitated.

According to the solar cell module 1 of the present embodiment, a texture like a blind can be exhibited. Further, according to the solar cell module 1 of the present embodiment, by locating the bus bar electrode 30 near to the end in the longitudinal direction of the solar cell 12, the portion shaded by the bus bar electrode 30 can be reduced, so that power generation efficiency can be improved.

According to the method for manufacturing the solar cell module 1 of the present embodiment, most of the raw material solar cell 70 can be produced by conventional solar cell manufacturing apparatuses. Therefore, there is no need to install new equipment, so that the initial cost of the manufacturing can be reduced.

In the cell dividing step described above, the raw material solar cell 70 is cut at a plurality of cutting positions (positions along the respective dividing lines CL), but the cutting order may be appropriately changed. In the cell dividing step, the raw material solar cell 70 may be divided into a plurality of small pieces in advance, and then the small pieces may be further divided.

For example, in the cell dividing step, the raw material solar cell 70 may be cut along the dividing lines CL1 to CL6 (see Fig. 15) in advance, and then the first raw material part 120 and the second raw material parts 121a, 121b may be divided into strips. For example, in the cell dividing step, the raw material solar cell 70 may be cut along the dividing lines CL1, CL2 extending in the second direction, and then cut along each of the dividing lines CL extending in the first direction.

When the raw material solar cell 70 is cut at each of the plurality of cutting positions, it may be cut by repeating a procedure in which the dividing groove 128 is formed at a predetermined cutting position to fold and cut there, and then the dividing groove 128 is formed at another cutting position to fold and cut there.

On the other hand, the folding step may be performed at each cutting position after the dividing grooves 128 are formed at all (a plurality of) cutting positions in advance. That is, the raw material solar cell 70 may be finally cut at all cutting positions.

In the above embodiment, the low rigidity part 83 having the three through hole rows 41 (see Fig. 14) has been described as an example, but a low rigidity part to be formed in the bus bar electrode 80 is not limited thereto.

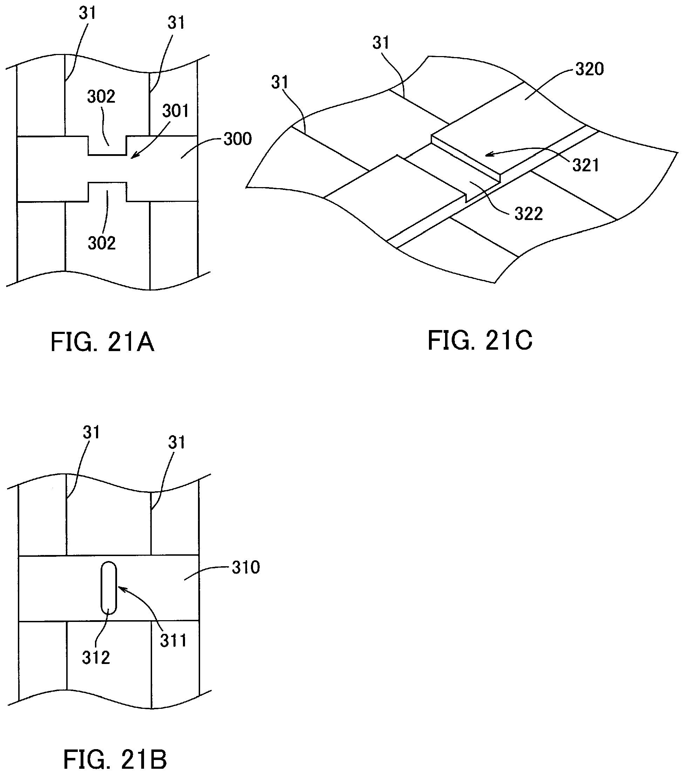

The low rigidity part may be, for example, a low rigidity part 301 formed by providing a plurality of (two) notches 302 (missing parts) in a predetermined region to be a part of the bus bar electrode 300, as shown in Fig. 21A. The low rigidity part 301 is a portion thinner than the other surrounding portions (the width direction length of the bus bar electrode 300 is shorter).

The notches 302 are portions formed by missing each of both ends (edge portions) in the width direction of the bus bar electrode 300, the plan view shape of which is substantially polygonal (substantially quadrangular) and extends from the end toward the center in the width direction thereof.

In addition, the low rigidity part may be a low rigidity part 311 formed by providing one through hole part 312 (through hole, groove portion) in a predetermined region to be a part of the bus bar electrode 310, as shown in Fig. 21B.

The through hole part 312 is a long hole extending in the width direction of the bus bar electrode 310, and is also a through hole penetrating the bus bar electrode 310. The through hole part 312 is also a groove-shaped portion extending linearly.

That is, the opening shape of the through hole part 312 is not limited to the circular shape described above, and may be an elliptical shape. Alternatively, the opening shape of the through hole part 312 may be a fan shape or a polygonal shape, or may be a shape in which these figures are partially distorted or missing.

Additionally, the low rigidity part may be a low rigidity part 321 formed by providing a thin part 322 in which a predetermined region to of the bus bar electrode 320 is partly made thinner than other surrounding portions, as shown in Fig. 21C. The thin part 322 is a portion having a smaller thickness than the surrounding portions, and has a shorter length in the thickness direction of the bus bar electrode 320 (thickness direction of the raw material solar cell 70) than the surrounding portions. In other words, it can be said that the thin part 322 is a recess recessed in the thickness direction of the bus bar electrode 330.

As described above, the low rigidity part may form any one of the structures including the notches 38, 302, the through hole parts 40, 312, the through hole row 41, and the thin part 322 described above, or may form a structure by combining a plurality of structures selected from these structures. That is, any one of the following (1) to (4) may be formed in the low rigidity part constituting the cutting region:
(1) one or more through holes;
(2) one or more notches;
(3) one or more recesses; and
(4) one or more grooves.

In this case, the shape of the hole or groove formed in the bus bar electrode, the length of the groove (long hole), the shape of the recess, and the like may be appropriately changed. That is, the low rigidity part may be a portion having a lower rigidity than the surroundings.

In the solar cell formed by cutting such a low rigidity part in the dividing step, the cut structure mark part, created after the low rigidity part is cut, becomes the notch and/or the thin part.

In the laser processing step of the above embodiment, an example has been described in which laser light is emitted from the second main surface 76 side, but the present invention is not limited thereto, and laser light may be emitted from the first main surface 75 side. That is, in the laser processing step, the electrodes on the first main surface 75 side may be divided by the laser processing step, and the electrodes on the second main surface 76 side may be divided by the folding step.

In the above embodiment, an example has been described in which the first interconnector 52 is adopted as a connection member for connecting the two solar cells 12a, 12b arranged adjacent to each other in the cell row 60. However, the connection member of the present invention is not limited thereto.

When the two solar cells 12a, 12b are connected, the first bus bar electrode 30a of one solar cell 12 and the second bus bar electrode 30b of the other solar cell 12 may be overlapped with each other via a conductive adhesive and they may be electrically connected to each other, instead of the cell row 60 described above. As described above, when the bus bar electrodes 30, 30 of the adjacent solar cells 12, 12 are bonded to each other, a conductive adhesive serves as a connection member.

In addition, when the bus bar electrodes 30, 30 of the adjacent solar cells 12, 12 are bonded to each other, the first bus bar electrode 30a of one solar cell 12 and the second bus bar electrode 30b of the other solar cell 12 may be stacked to be in direct contact with each other and they may be directly connected by ultrasonic bonding or the like, without using a conductive adhesive.

In the above embodiment, an example has been shown in which a part of the main body portion of the raw material solar cell 70 and the second bus bar electrode 80b are divided by the laser processing step to form the dividing groove 128. However, the cell dividing step of the present invention is not limited thereto.

That is, instead of the laser processing step described above, a groove forming step of forming the dividing groove 128 using a cutting tool such as a diamond wire, for example, a cutting tool for cutting out silicon wafers from an ingot may be performed.

In the above embodiment, an example has been shown in which the low rigidity parts 83 are formed at the cutting positions and the vicinities thereof on the bus bar electrode 80 in the cell dividing step, but the present invention is not limited thereto.

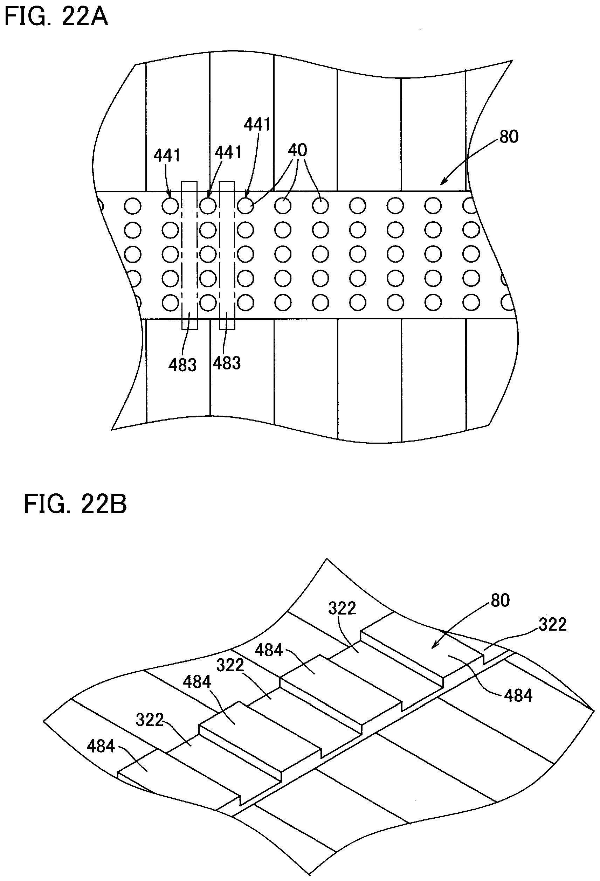

In the bus bar electrode 80, for example, a plurality of through hole rows 441 may be provided over the entire area in the longitudinal direction of the bus bar electrode 80, and each high rigidity parts 483 may be provided between the through hole rows 441, as shown in Fig. 22A. The high rigidity part 483 is a portion of the bus bar electrode 80, where the through hole part 40 is not formed between one end and the other end in the width direction.

Similarly, the bus bar electrode 80 may be formed such that a plurality of the thin parts 322 are arranged in a row over the entire area in the longitudinal direction of the bus bar electrode 80 and high rigidity parts 484 are each formed between the thin parts 322, as shown in Fig. 22B.

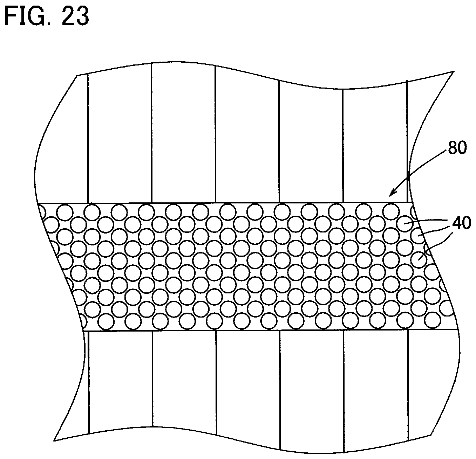

Alternatively, the bus bar electrode 80 may have a structure in which the through hole parts 40 are provided to spread the entire area of the bus bar electrode 80, as shown in Fig. 23. That is, the bus bar electrode 80 may have a structure in which its overall rigidity becomes lower than usual. That is, the notch 302 (see Fig. 21A) and the thin part 322 (see Fig. 21C), described above, may be formed over the entire area in the longitudinal direction of the bus bar electrode 80.

In the above embodiment, the four finger electrodes 31a, 31b are provided on each of the main surfaces 25, 26, but the number of the finger electrodes 31a, 31b is not limited. One finger electrode may be provided on each of the main surfaces 25, 26, or two or more finger electrodes may be each provided. The numbers of the finger electrodes 31a, 31b may be different for both the main surfaces 25, 26.

In the above embodiment, two auxiliary electrodes 32a, 32b are provided on each of the main surfaces 25, 26, but the number of auxiliary electrodes 32a, 32b is not limited. One finger electrode may be provided on each of the main surfaces 25, 26, or two or more finger electrodes may be provided. The numbers of the auxiliary electrodes 32a, 32b may be different for both the main surfaces 25, 26.

In the above embodiment, each component can be freely replaced or added among the embodiments as long as it is included in the technical scope of the present invention.

### EXPLANATION OF REFERENCE SIGNS

1: solar cell module
12: solar cell
13: wiring member (connection member)
20: first transparent electrode layer (cell electrode layer)
21: second transparent electrode layer (cell electrode layer)
22: photoelectric conversion part
30, 300, 310, 320: bus bar electrode (connection electrode)
31: finger electrode (current collecting electrode)
31a: first finger electrode (first current collecting electrode)
31b: second finger electrode (second current collecting electrode)
32: auxiliary electrode
38, 302: notch (missing part)
39a: end surface part (cut surface part, cut surface)
39b: hole mark part (cut structure mark part)
40: through hole part (through hole)
43: laser processing region
44: folding region
60: cell row (cell group)
70: raw material solar cell
75: first main surface
76: second main surface
80: bus bar electrode (connection electrode formation part)
80a: first bus bar electrode (first connection electrode formation part)
80b: second bus bar electrode (second connection electrode formation part)
83, 301, 311, 321: low rigidity part (cutting region)
128: dividing groove
130: first transparent electrode layer (electrode layer)
131: second transparent electrode layer (electrode layer)
132: photoelectric conversion part
312: through hole part (through hole, groove portion)
322: thin part

## Claims

1. A method for manufacturing a solar cell module including a plurality of solar cells, the plurality of solar cells being electrically connected directly or via a connection member,
wherein the solar cell includes:
a cell electrode layer; and
a connection electrode,
the plurality of solar cells including a first and a second solar cells,
the connection electrode of the first solar cell being configured to connect the connection member or the connection electrode of the second solar cell to the cell electrode layer of the first solar cell,
wherein the method comprises:
(a) manufacturing a raw material solar cell,
the raw material solar cell comprising:
a pair of electrode layers;
a photoelectric conversion part sandwiched between the pair of electrode layers; and
a connection electrode formation part; and
(b) dividing the raw material solar cell into plural pieces to form the solar cells, and
wherein step (b) comprises cutting the connection electrode formation part to form the connection electrode.

2. The method according to claim 1,
wherein the connection electrode formation part includes a cutting region with a lower flexural rigidity than other portions in the connection electrode formation part, and
wherein step (b) comprises cutting the cutting region.

3. The method according to claim 2, wherein the cutting region comprises at least one of the following (1) to (4):
(1) one or more through holes,
(2) one or more notches,
(3) one or more recesses, and
(4) one or more grooves.

4. The method according to claim 2 or 3, wherein step (b) comprises:
(c) forming_a dividing groove in the raw material solar cell by laser-processing; and
(d) folding and cutting the raw material solar cell along the dividing groove after step (c).

5. The method according to claim 4,
wherein the raw material solar cell includes: a first main surface; and a second main surface,
wherein the connection electrode formation part includes: a first connection electrode formation part provided on the first main surface side; and
a second connection electrode formation part provided on the second main surface side, and
wherein the cutting region of the first connection electrode formation part is divided in step (d) whereas the cutting region of the second connection electrode formation part is divided in step (c).

6. The method according to any one of claims 1 to 5,
wherein the raw material solar cell includes: a first main surface; a second main surface; and a current collecting electrode,
the current collecting electrode including:
a first current collecting electrode provided on the first main surface side; and
a second current collecting electrode provided on the second main surface side, and
wherein when the raw material solar cell is planarly viewed, the first current collecting electrode extends in the same direction as the second current collecting electrode while most of the first current collecting electrode overlaps with the second current collecting electrode.

7. The method according to any one of claims 1 to 6, further comprising:
(e) converting light energy into electric energy by connecting an external load to the raw material solar cell before step (b).

8. A solar cell module including a cell group having a plurality of solar cells electrically connected directly or via a connection member,
wherein the solar cell comprises:
a pair of cell electrode layers;
a photoelectric conversion part sandwiched between the pair of cell electrode layers; and
a connection electrode extending in a predetermined direction,
wherein the plurality of solar cells include a first and a second solar cells,
wherein the connection electrode of the first solar cell is configured to connect the connection member or the connection electrode of the second solar cell to the cell electrode layer of the first solar cell, and
wherein the connection electrode comprises:
a cut surface part forming an end surface in a longitudinal direction; and
a cut structure mark part continuous with the cut surface part,
the cut structure mark part being a notch and/or a thin part.

9. The solar cell module according to claim 8, wherein the connection electrode includes a through hole in a longitudinal middle part, the through hole penetrating in a thickness direction.

10. The solar cell module according to claim 8 or 9,
wherein the cell group is constituted by arranging linearly the plurality of solar cells, and
wherein when planarly viewed, a longitudinal direction of the connection electrode intersects with a row direction of the plurality of solar cells.

11. The solar cell module according to any one of claims 8 to 10,
wherein a side surface of the solar cell comprises:
a laser processing region including a laser-processed mark; and
a folding region including a folded mark, and
wherein the laser processing region has a surface roughness larger than a surface roughness of the folding region.

12. The method according to any one of claims 8 to 11,
wherein the solar cell extends in a predetermined direction with a width, the solar cell having a longitudinal direction length longer than 5 times and shorter than 100 times its width,
wherein the solar cell includes: a current collecting electrode; and an auxiliary electrode, the current collecting electrode extending along a longitudinal direction of the solar cell; the auxiliary electrode and the connection electrode extending in a direction intersecting with the longitudinal direction of the solar cell when planarly viewed, each of the auxiliary electrode and the connection electrode being in contact with the current collecting electrode,
wherein the connection electrode is located at or near one end in the longitudinal direction of the solar cell; and
wherein the auxiliary electrode is located between the center and the other end in the longitudinal direction of the solar cell.

13. A solar cell module including a cell group having a plurality of solar cells connected directly or via a connection member,
wherein the solar cell extends in a predetermined direction with a width, the solar cell having a longitudinal direction length longer than 5 times and shorter than 100 times its width,
wherein the solar cell comprises:
a pair of cell electrode layers;
a photoelectric conversion part sandwiched between the pair of cell electrode layers;
a connection electrode;
a current collecting electrode; and
an auxiliary electrode,
the plurality of solar cells including a first and a second solar cells,
the connection electrode of the first solar cell being configured to connect the connection member or the connection electrode of the second solar cell to the cell electrode layer of the first solar cell,
the current collecting electrode extending in a longitudinal direction of the solar cell from the connection electrode,
the auxiliary electrode and the connection electrode extending in a direction intersecting with the longitudinal direction of the solar cell when planarly viewed, each of the auxiliary electrode and the connection electrode being in contact with the current collecting electrode,
wherein the connection electrode is located near one end in the longitudinal direction of the solar cell, and
wherein the auxiliary electrode is located between the center and the other end in the longitudinal direction of the solar cell.

14. A solar cell module including a cell group having a plurality of solar cells electrically connected directly or via a connection member,
wherein the solar cell comprises:
a pair of cell electrode layers;
a photoelectric conversion part sandwiched between the pair of cell electrode layers;
a connection electrode; and
a current collecting electrode,
the plurality of solar cells including a first and a second solar cells,
the connection electrode of the first solar cell being configured to connect the connection member or the connection electrode of the second solar cell to the cell electrode layer of the first solar cell,
the current collecting electrode extending in a longitudinal direction of the solar cell,
the connection electrode with a width extending in a direction intersecting with the longitudinal direction of the solar cell when planarly viewed,
the connection electrode having a width larger than a width of the current collecting electrode, the connection electrode having an end surface constituted by a cut surface in its extending direction.

15. A raw material solar cell that includes a connection electrode formation part and that is to be divided into a plurality of solar cells by cutting the connection electrode formation part,
the raw material solar cell including:
a pair of electrode layers; and
a photoelectric conversion part sandwiched between the pair of electrode layers,
wherein the photoelectric conversion part is configured to convert light energy into electric energy,
wherein the connection electrode formation part is configured to be electrically connected to the electrode layer, the connection electrode formation part including a cutting region with a flexural rigidity lower than other portions; and
wherein the light energy can be converted into the electric energy for extraction by connecting an external load to the connection electrode formation part.
